(19) Europäisches Patentamt
European Patent Office
Office européen des brevets

(11) **EP 3 910 374 A1**

(12) **EUROPEAN PATENT APPLICATION**
published in accordance with Art. 153(4) EPC

(43) Date of publication:
**17.11.2021 Bulletin 2021/46**

(51) Int Cl.:
**G01S 7/484** (2006.01)   **G01S 17/08** (2006.01)
**H01S 5/042** (2006.01)

(21) Application number: **19908896.4**

(22) Date of filing: **09.01.2019**

(86) International application number:
**PCT/CN2019/071035**

(87) International publication number:
**WO 2020/142949 (16.07.2020 Gazette 2020/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: SZ DJI Technology Co., Ltd.
**Shenzhen, Guangdong 518057 (CN)**

(72) Inventors:
• **HUANG, Senhong**
  **Shenzhen, Guangdong 518057 (CN)**
• **MA, Liangliang**
  **Shenzhen, Guangdong 518057 (CN)**
• **LIU, Xiang**
  **Shenzhen, Guangdong 518057 (CN)**

(74) Representative: **Appelt, Christian W.**
  **Boehmert & Boehmert**
  **Anwaltspartnerschaft mbB**
  **Pettenkoferstrasse 22**
  **80336 München (DE)**

(54) **LIGHT EMITTING DEVICE, DISTANCE MEASURING DEVICE AND MOBILE PLATFORM**

(57)  The present disclosure relates to a light emitting device, the light emitting device including at least two laser emission circuits, each of the laser emission circuits including a power supply, a laser emitter, an energy storage circuit, and a control circuit. In each of the laser emission circuits, the control circuit is configured to turn on the energy storage circuit and the power supply in the laser emission circuit in a first period of time for the power supply to store energy in the energy storage circuit. The control circuit is further configured to turn on the laser emitter and the energy storage circuit in the laser emission circuit in a second period of time for the energy storage circuit to supply power to the laser emitter for the laser emitter to emit a light pulse signal, where two or more laser emission circuits share the power supply. The light emitting device can realize the calibration of light energy of different laser emitters, and compensate for the difference of each circuit. Further, the multi-circuit laser emitters can meet the human eye safety regulations, simplify the circuit, and reduce the hardware cost.

**FIG. 1**

## Description

## TECHNICAL FIELD

The present disclosure relates to the technical field of circuits and, more specifically, to a light emitting device, a distance measuring device, a mobile platform, a lidar, and a laser distance measuring device, which can be applied to other products based on time-of-flight (TOF) technology.

## BACKGROUND

In the field of lidar, laser distance measuring device, etc. since the products are directly used in real life scenarios, there is a risk that the laser will directly enter the human eye. Therefore, Accessible Emission Limit (AEL) stipulates that the laser emission cannot exceed the energy value of the safety regulations, thereby ensuring that even if the laser enters the human eye, it will not cause human injury. Therefore, in the design of the laser emission technical solutions, the optical power should be increased as much as possible under the premise of being less than the safety limit, thereby achieving a longer detection range.

In the design of the multi-circuit laser emission driving technical solution, due to the individual differences of the light emitter or the elements of the driving circuit, the use of the same emission driving technical solution will cause the difference in the light output power of each circuit, and thus the difference in detection distance, which affects the consistency of the performance of each circuit. For the same light emitter, the lamination power will decrease as the working temperature rises, at the same time, as the working time ages, the photoelectric conversion efficiency will gradually decrease. Therefore, in the multi-circuit emission technical solution, it is needed to realize the power adjustment of each circuit to compensate for individual differences in elements, temperature changes, and aging attenuation differences.

## SUMMARY

The present disclosure proposes to solve at least one of the above-mentioned problems. The present disclosure provides a light emitting device, which can improve the problem of the difference in the output light power of each circuit and the difference in detection distance in the conventional multi-circuit laser emission driving technical solution, which affects the consistency of the performance of each circuit. A first aspect of the present disclosure provides a light emitting device. The light emitting device includes at least two laser emission circuits, each of the laser emission circuits including a power supply, a laser emitter, an energy storage circuit, and a control circuit. In each of the laser emission circuits, the control circuit is configured to turn on the energy storage circuit and the power supply in the laser emission circuit in a first period of time for the power supply to store energy in the energy storage circuit. The control circuit is further configured to turn on the laser emitter and the energy storage circuit in the laser emission circuit in a second period of time for the energy storage circuit to supply power to the laser emitter for the laser emitter to emit a light pulse signal, where two or more laser emission circuits share the power supply.

Further, in the at least two laser emission circuits, the laser emitter in each laser emission circuit is configured to emit a light pulse sequence, and the at least two laser emission circuits alternately emit the light pulse sequence.

Further, between two adjacent emission of the light pulse signals of one laser emission circuit of the at least two laser emission circuits, a remaining laser emission circuit of the at least two laser emission circuits respectively emit one light pulse signal in sequence.

Further, the two or more laser emission circuits share at least part of the control circuit.

Further, the control circuit is configured to control the laser emission circuits in different periods of time and output light signals of the laser emitters in the laser emission circuits in different periods of time.

Further, the control circuit includes a first switch circuit and a second switch circuit. In each of the laser emission circuits, the first switch circuit is configured to turn on and off a connection between the power supply and the energy storage circuit of the laser emission circuit based on a drive signal, and the second switch circuit is configured to turn on and off a connection between the energy storage circuit and the laser emitter based on the drive signal.

Further, two laser emission circuits share the first switch circuit and/or the second switch circuit.

Further, the first switch circuit is configured to control a conduction and disconnection of the energy storage circuit in different laser emission circuits and the power supply in different periods of time based on the drive signal, and/or the second switch circuit is configured to control a conduction and disconnection of the energy storage circuit in different laser emission circuits and the laser emitter in different periods of time based on the drive signal.

Further, in at least one laser emission circuit, the energy storage circuit includes an inductor and a capacitor, and the first switch circuit and the second switch circuit are the same switch circuit. The switch circuit is configured to turn on and off the connection between the power supply and the energy storage circuit of the laser emission circuit, and turn on and off the connection between the energy storage circuit and the laser emitter based on the drive signal.

Further, the first switch circuit and the second switch circuit are the same switch circuit, and the same switch circuit is configured to implement the functions of the first switch circuit and the second switch circuit respectively in time sequence.

Further, in the at least two laser emission circuits, pulse widths for controlling the first switch circuit in the at least two laser emission circuits are different and/or the pulse widths for controlling the second switch circuit in the at least two laser emission circuits are different.

Further, at least two laser emission circuits share at least part of the energy storage circuit.

Further, the energy storage circuit stores energy in different periods of time and supplies power to the laser emitters in different laser emission circuits in different periods of time.

Further, the energy storage circuit includes a resistor and a capacitor.

Further, the two or more laser emission circuits share the resistor and/or the capacitor.

Further, in the first period of time, a first loop is turned on, the first loop including the power supply, the resistor, and the capacitor connected in series, the power supply charging the capacitor through the resistor. In the second period of time, a second loop is turned on, the second loop including the capacitor and the laser emitter connected in series.

Further, the energy storage circuit includes an inductor and a capacitor.

Further, the two or more laser emission circuits share the inductor and/or the capacitor.

Further, the first period of time includes a third period of time and a fourth period of time. In one laser emission circuit, in the third period of time, the first loop is turned, the first loop including the power supply and the inductor connected in series, and the power supply is used to charge the inductor; in the fourth period of time, the second loop is turned on, the second loop including the inductor and the capacitor connected in series, and the inductor is used to charge the capacitor; and in the second period of time, a third loop is turned on and the capacitor and the laser emitter are turned on.

Further, the third period of time and the second period of time at least partially overlap.

Further, the control circuit includes a switch circuit for turning on and off based on the drive signal. The first loop includes the power supply, inductor, a first diode, the laser emitter, and the switch circuit connected in series. The second loop includes the inductor, the first diode, and the capacitor connected in series. The third loop includes the capacitor, the laser emitter, and the switch circuit.

Further, the control circuit includes a switch circuit for turning on and off based on the drive signal. The first loop includes the power supply, the inductor, the first diode, and the switch circuit connected in series. The second loop includes the inductor, the first diode, the second diode, and the capacitor connected in series. The third loop includes the capacitor, the laser emitter, and the switch circuit connected in series.

Further, the control circuit includes a first switch circuit and a second switch circuit, the first switch circuit being connected to each laser emitter in the at least two laser emission circuits through the resistor, one end of the capacitor being connected to the resistor and a common end of each laser emitter in the at least two laser emission circuits, and the other end being connected to each second switch circuit in the at least two laser emission circuits.

Further, each laser emission circuit includes one second switch circuit, the second switch circuit including a field effect tube, a first end of the second switch circuit being configured to receive the drive signal, a second end being connected to the capacitor, and a third end being connected to the resistor.

Further, the laser emitter in each laser emission circuit is positioned between the second end of the second switch circuit and the capacitor, or between the third end and the resistor.

Further, a first diode is included. The control circuit includes a first switch circuit and a second switch circuit. One end of the inductor is connected to the power supply, and the other end is connected to a third end of the first switch circuit. One end of the capacitor is connected to a common end of the first diode and each laser emitter in the at least two laser emission circuits, and the other end is connected to each second switch circuit in the at least two laser emission circuits. The second switch circuit includes a field effect tube.

Further, a first end of the first switch circuit is configured to receive the drive signal, and the third end is grounded.

Further, each laser emission circuit includes one second switch circuit. A first end of the second switch circuit is configured to receive the drive signal, a second end is connected to the capacitor, and a third end is connected to the inductor.

Further, the laser emitter in each laser emission circuit is positioned between the second end of the second switch circuit and the capacitor, or between the third end and the inductor.

Further, one end of the first diode is connected to the inductor, and the other end is connected to each laser emitter in the at least two laser emission circuits.

Further, a first diode is included. The control circuit includes a third switch circuit. One end of the inductor is connected to the power supply, the other end is connected to the capacitor and a common end of each laser emitter in the at least two laser emission circuits through the first diode. One end of the capacitor is connected to a common end of the first diode and each laser emitter in the at least two laser emission circuits, the other end is connected to each third switch circuit in the at least two laser emission circuits.

Further, a first end of the third switch circuit is configured to receive the drive signal, a second end is configured to connect the capacitor, and a third end is configured to connect the inductor.

Further, the laser emitter in each laser emission circuit is positioned between the second end of the third switch circuit and the capacitor, or between the third end and the inductor.

Further, a first diode is included. The control circuit includes a third switch circuit. One end of the inductor is connected to the power supply, the other end is connected to a common end of each first diode in the at least two laser emission circuits. One end of the capacitor is grounded, the other end is connected to a common end of each second diode in the at least two laser emission circuits.

Further, each of the at least two laser emission circuits includes the first diode, the third switch circuit, the second diode, and the laser emitter.

Further, in each laser emission circuit, a first end of the third switch circuit is configured to receive the drive signal, a second end is grounded, and a third end is connected to the common end of the first diode and the second diode.

Further, the second diode in each laser emission circuit is connected in anti-parallel to both ends of the laser emitter.

Further, the at least two laser emission circuits emit light pulse signals in different directions.

Further, emission chips in the laser emitters in the at least two laser emission circuits are packaged in a same enclosed space.

Further, the light emitting device also includes a reset circuit.

Further, the reset circuit includes a switch circuit, which is connected to the energy storage circuit.

Further, the reset circuit is configured to reset the voltage on at least part of the circuit on the energy storage circuit before and/or after the laser emitter emits the light pulse.

Further, in at least part of the circuits, parameters of the energy storage circuit of different circuits are different.

Further, in at least part of the circuits, the conduction time of the energy storage circuit and the power supply are different; and/or the conduction time of the energy storage circuit and the laser emitter are different.

In a second aspect, an embodiment of the present disclosure further provide a distance measuring device including the light emitting device in the first aspect, and at least two detection circuits respectively corresponding to the at least two laser emission circuits. Each detection circuit includes a photoelectric conversion circuit configured to receive at least part of an optical signal of the laser pulse signal emitted by the corresponding laser emission circuit reflected by an object, and convert the received optical signal into an electrical signal; a sampling circuit configured to sample the electrical signal from the photoelectric conversion circuit to obtain a sampling result; and an arithmetic circuit configured to calculate a distance between the object and the distance measuring device based on the sampling result.

Further, the at least two detection circuits share at least part of the sampling circuit; and/or the at least two detection circuits share at least part of the arithmetic circuit.

Further, the distance measuring device also includes a scanning module .The scanning module is configured to emit the laser pulse signal from the light emitting device after changing its transmission direction, and transmit the laser pulse signal reflected by the object to a detection circuit after passing through the scanning module.

Further, the scanning module includes a driver and a prism with uneven thickness. The driver is configured to drive the prism to rotate to change the laser pulse signal passing through the prism to different directions.

Further, the scanning module includes two drivers, and two parallel prisms with uneven thickness. The two drivers are configured to drive the two prisms to rotate in opposite directions. The laser pulse signal from the light emitting device changes the transmission direction and emitting after passing through the two prisms.

In a third aspect, an embodiment of the present disclosure further provides a mobile platform. The mobile platform includes any light emitting device described in the first aspect and a platform body. The distance measuring device is mounted on the platform body.

Further, the mobile platform includes at least one of an unmanned aerial vehicle, a car, and a remote control car.

The present disclosure provides the above-mentioned light emitting device, distance measuring device, and mobile platform to provide a multi-circuit emission solution that can realize the power adjustment of each circuit, thereby compensating for individual element differences, temperature changes, aging and attenuation differences, etc.

## BRIEF DESCRIPTION OF THE DRAWINGS

In order to illustrate the technical solutions in accordance with the embodiments of the present disclosure more clearly, the accompanying drawings to be used for describing the embodiments are introduced briefly in the following. It is apparent that the accompanying drawings in the following description are only some embodiments of the present disclosure. Persons of ordinary skill in the art can obtain other accompanying drawings in accordance with the accompanying drawings without any creative efforts.

FIG. 1 is a schematic diagram of a first laser emission solution according to an embodiment of the present disclosure.

FIG. 2 is a schematic diagram of a relationship between a control signal and a boosted voltage output voltage in the first laser emission solution according to an embodiment of the present disclosure.

FIG. 3 is a schematic diagram of a timing relationship between the control signal and a light emitting signal according to an embodiment of the present disclosure.

FIG. 4 is a schematic diagram of another timing relationship between the control signal and the light emitting signal according to an embodiment of the present disclosure.

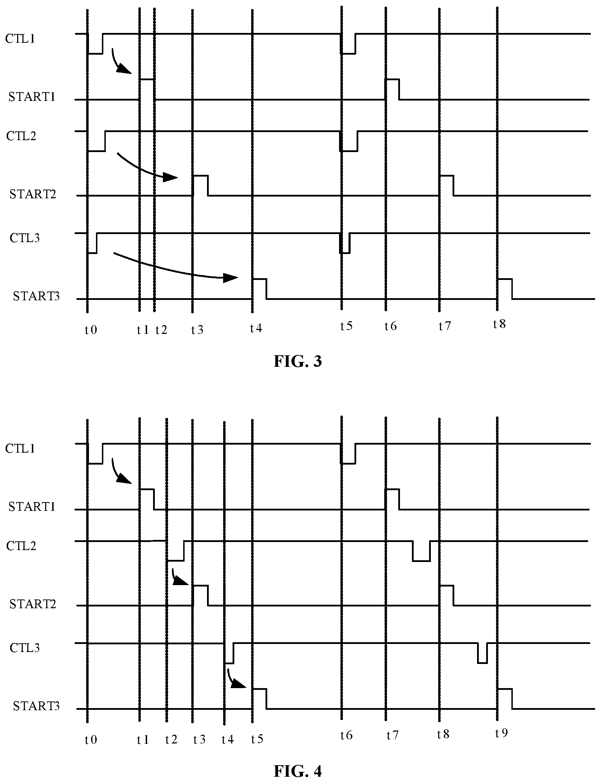

FIG. 4 is a schematic diagram of another timing relationship between the control signal and the light emitting signal according to an embodiment of the present disclosure.

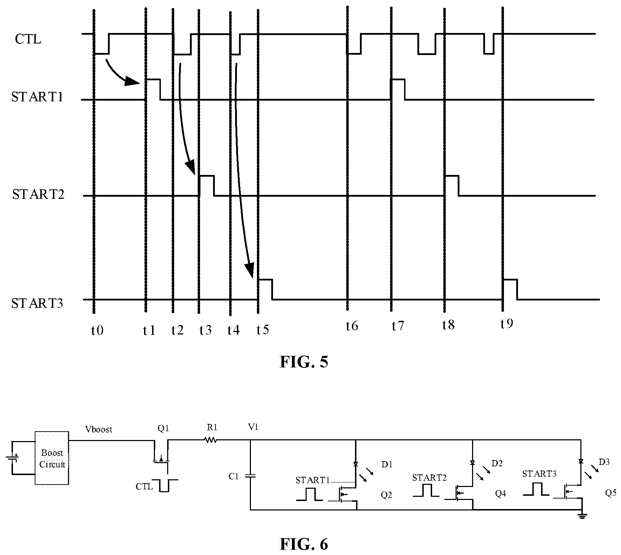

FIG. 6 is schematic diagram of a second laser emission solution according to an embodiment of the present disclosure.

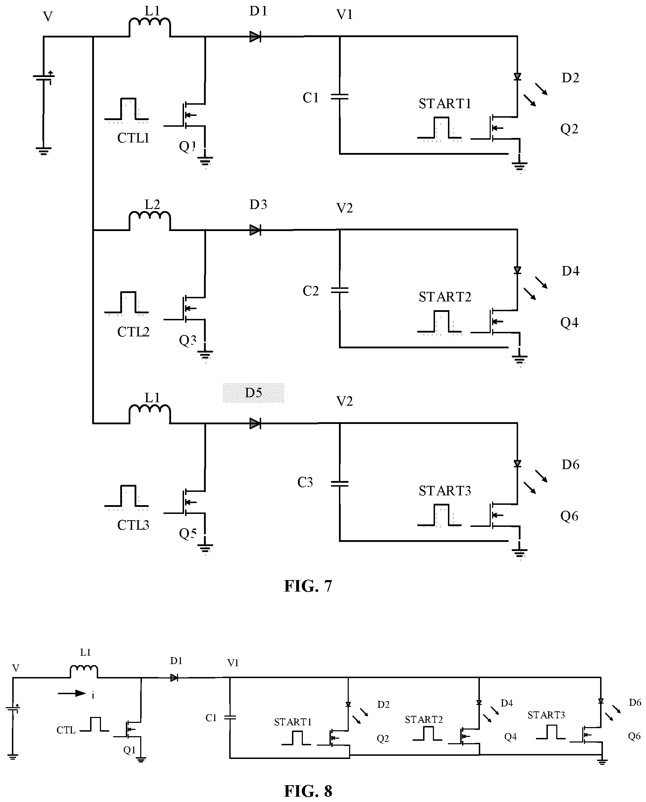

FIG. 7 is schematic diagram of a third laser emission solution according to an embodiment of the present disclosure.

FIG. 8 is schematic diagram of a fourth laser emission solution according to an embodiment of the present disclosure.

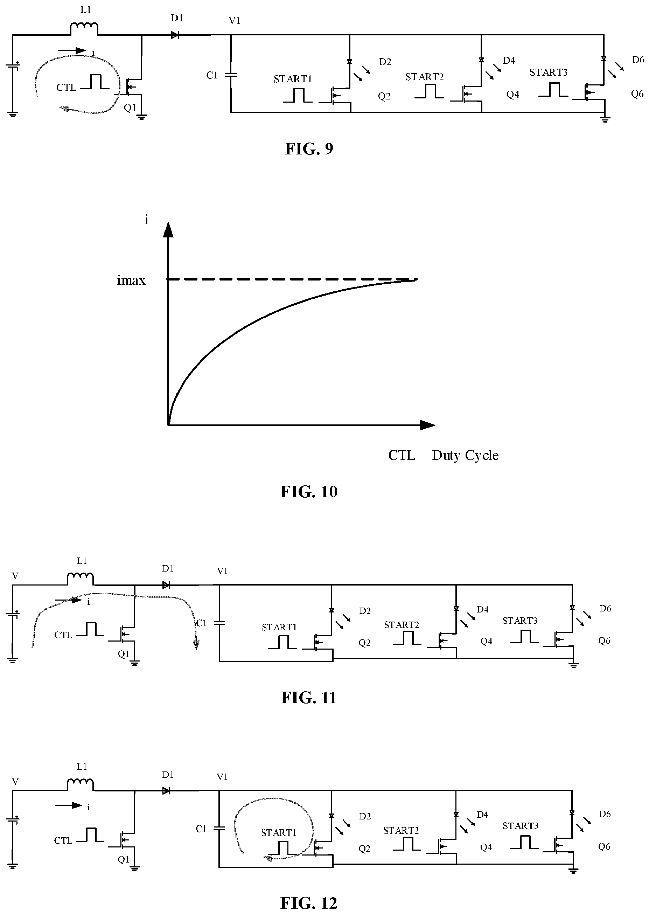

FIG. 9 is schematic diagram of an inductive charging loop in the fourth laser emission solution according to an embodiment of the present disclosure.

FIG. 10 is a schematic diagram of a relationship between the control signal and a current in an inductor in the fourth laser emission solution according to an embodiment of the present disclosure.

FIG. 11 is a schematic diagram of a capacitor charging path by the inductor in the fourth laser emission solution according to an embodiment of the present disclosure.

FIG. 12 is a schematic diagram of a discharge path of the first light emission element in the fourth laser emission solution according to an embodiment of the present disclosure.

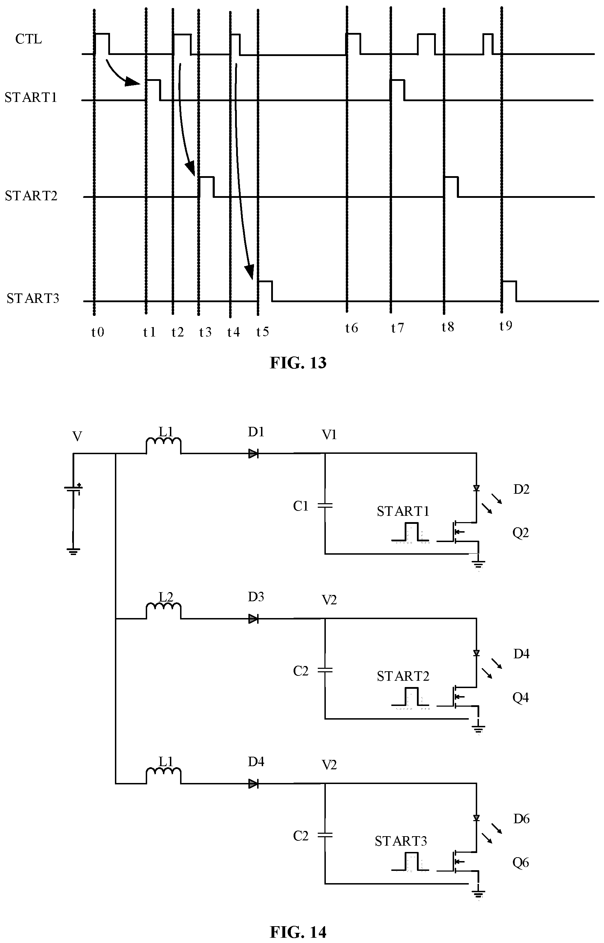

FIG. 13 is a schematic diagram of a control sequence of the fourth laser emission solution according to an embodiment of the present disclosure.

FIG. 14 is a schematic diagram of a fifth laser emission solution according to an embodiment of the present disclosure.

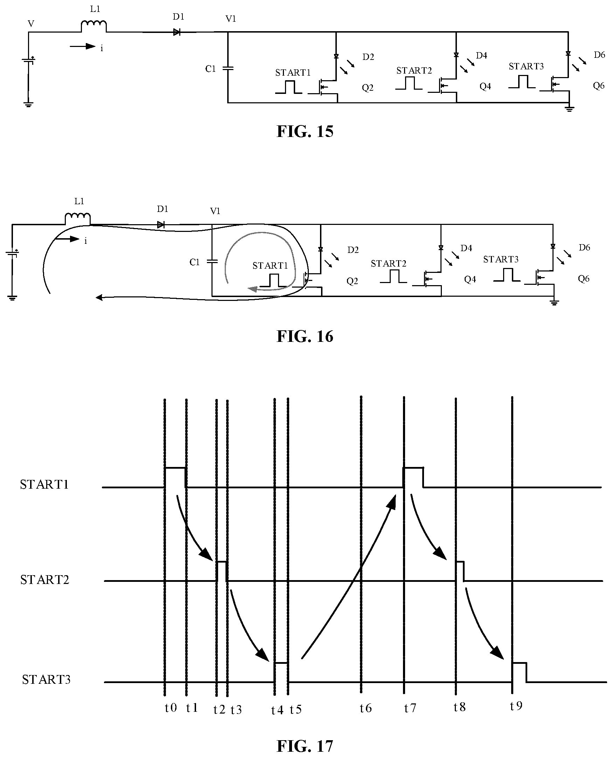

FIG. 15 is a schematic diagram of a sixth laser emission solution according to an embodiment of the present disclosure.

FIG. 16 is a schematic diagram of the charging path and the discharging path in the sixth laser emission solution according to an embodiment of the present disclosure.

FIG. 17 is a schematic diagram of the control sequence of the sixth laser emission solution according to an embodiment of the present disclosure.

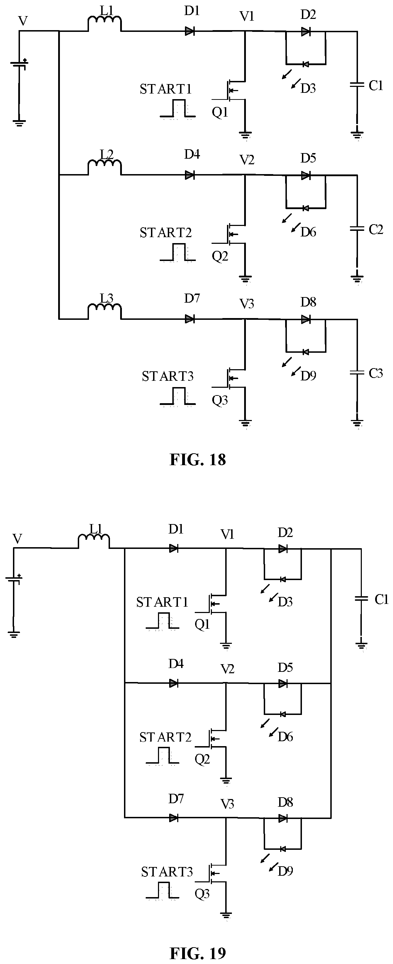

FIG. 18 is a schematic diagram of a seventh laser emission solution according to an embodiment of the present disclosure.

FIG. 19 is a schematic diagram of an eighth laser emission solution according to an embodiment of the present disclosure.

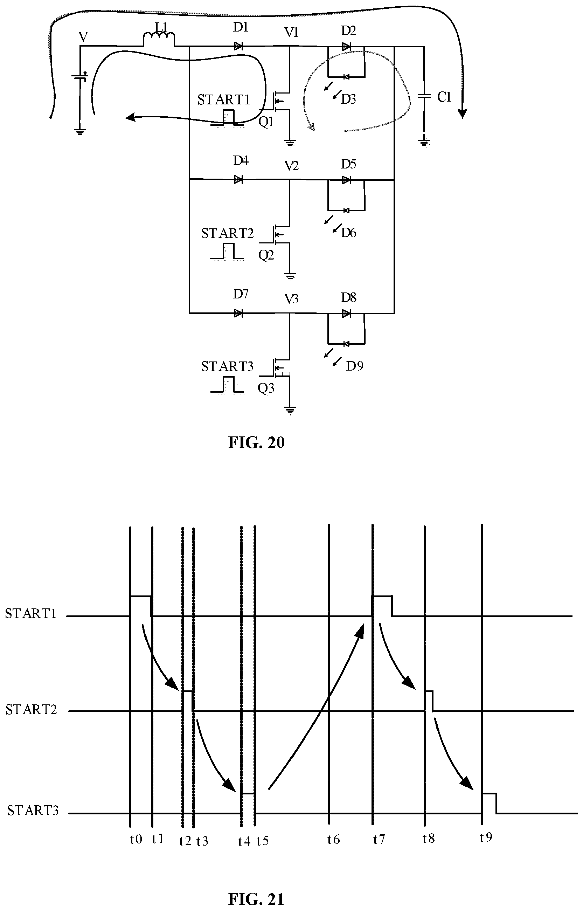

FIG. 20 is a schematic diagram of the charging path and the discharging path in the eighth laser emission solution according to an embodiment of the present disclosure.

FIG. 21 is a schematic diagram of the control sequence of the eighth laser emission solution according to an embodiment of the present disclosure.

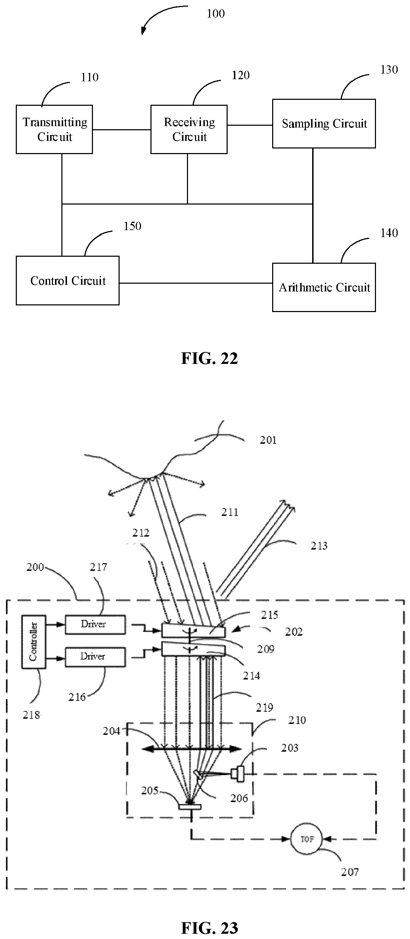

FIG. 22 is a frame diagram of a distance measuring device according to an embodiment of the present disclosure.

FIG. 23 is a schematic diagram of the distance measuring device adopting a coaxial optical path according to an embodiment of the present disclosure.

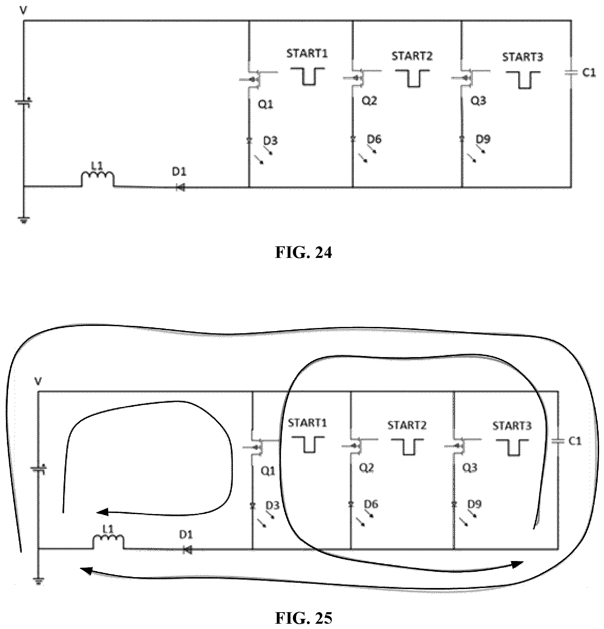

FIG. 24 is a schematic diagram of a ninth laser emission solution according to an embodiment of the present disclosure.

FIG. 25 is a schematic diagram of the charging path and the discharging path in the ninth laser emission solution according to an embodiment of the present disclosure.

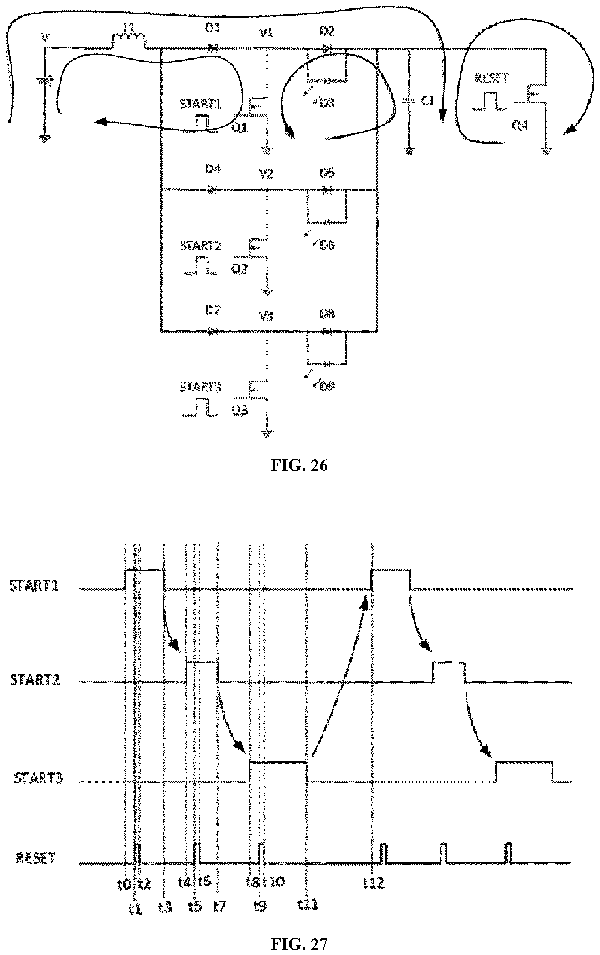

FIG. 26 is a schematic diagram of the charging path and the discharging path in a tenth laser emission solution according to an embodiment of the present disclosure.

FIG. 27 is a schematic diagram of the control sequence of the tenth laser emission solution according to an embodiment of the present disclosure.

**REFERENCE NUMERALS**

| 100, 200 | Distance measuring device |
|---|---|
| 201 | Object to be detected |
| 202 | Scanning module |
| 110 | Transmitting circuit |

| 103,203 | Transmitter |
| 120 | Receiving circuit |
| 104, 204 | Collimating element |
| 130 | Sampling circuit |
| 105,205 | Detector |
| 140 | Arithmetic circuit |
| 206 | Light path changing element |
| 207 | Optical flight time |
| 150 | Control circuit |
| 210 | Distance measuring module |
| 209 | Axis |
| 160, 202 | Scanning module |
| 214 | First optical element |
| 215 | Second optical element |
| 117,216 | Driver |
| 119, 219 | Collimated light beam |
| 211,213 | Light |
| 212 | Returned light |
| 218 | Controller |

## DETAILED DESCRIPTION OF THE EMBODIMENTS

Technical solutions of the present disclosure will be described in detail with reference to the drawings. It will be appreciated that the described embodiments represent some, rather than all, of the embodiments of the present disclosure. Other embodiments conceived or derived by those having ordinary skills in the art based on the described embodiments without inventive efforts should fall within the scope of the present disclosure.

The general implementation of a power supply for a multi-circuit light emitters is to configure an adjustable power supply for each light emitter separately (including but not limited to a triode feedback system, LDO, RC charging power supply, LC charging power supply). Since each light emitter is individually configured with various elements, more components are being used and the hardware costs are increasing.

The present disclosure can realize the independent adjustment of laser emission power, and is suitable for products with multi-circuit laser emission. The following advantages can be achieved by individually adjusting the multi-circuit laser emission. First, it can calibrate the optical energy of different light emitters and compensate for the difference of each circuit. Second, the light emitters of the multi-circuit light emitter can meet the restrictions of human safety. Third, it can simplify the circuit and reduce hardware cost. The embodiments of the present disclosure can achieve at least one of the above advantages. In some embodiments, two of the above three advantages can be realized at the same time, and in some other embodiments, all of the above three advantages can be realized.

The technical solutions of the present disclosure will be described below in conjunction with specific embodiments.

The present disclosure provides a light emitting device. The light emitter device may include at least two laser emitting circuits, and each of the laser emitting circuits may include a power supply, a laser transmitter, an energy storage circuit, and a control circuit. In each of the laser emitting circuits, the control circuit may be used for turning on the energy storage circuit and the power supply in this laser emitting circuit in a first period of time, such that the power supply can store energy for the energy storage circuit. The control circuit may also be used for turning on the laser transmitter and the energy storage circuit in the laser emitting circuit in a second period of time, such that the energy storage circuit can supply power to the laser transmitter, such that the laser transmitter can emit a light pulse signal. In some embodiments, the two or more laser emitting circuits may share the power supply. This technical solution reduces the hardware cost because at least two or more laser emitting circuits share the power supply.

In some embodiments, the power supply may include a supply terminal of VCC HV and a boost circuit. For example, the boost circuit may not be included. The light emitting device may include three laser emitting circuits. For example, it may also include any number of emitting circuits, such as two, four, etc. The laser transmitter may include a laser diode. The energy storage circuit may include a capacitor and an inductor. In some embodiments, the energy storage circuit may include a capacitor and a resistor. The number of inductors of resistors can be selected based on the system. For example, one may be selected, or two or more may be selected. In some embodiments, the number of capacitors can be selected based on the conditions of the system. For example, one may be selected, or two or more may be selected. The control circuit may include a transistor. For example, a bipolar transistor or a field effect transistor may be selected.

In some embodiments, the two or more light emitting circuits may share the power supply, and in each laser emitting circuit, the power supply may be connected to an energy storage circuit for storing energy for the energy storage circuit for at least part of the time. The energy storage circuit may include a capacitor and an inductor, and/or a resistor. The capacitor may be connected to a power source through the inductor and/or the resistor, and the capacitor may be connected to the laser transmitter. The control circuit may include a transistor. For example, the transistor may be an NMOS or PMOS transistor. The control circuit may be used for turning on the energy storage circuit and the power supply in this laser emitting circuit in a first period of time, such that the power supply can store energy for the energy storage circuit. The control circuit may also be used for turning on the laser transmitter and the energy storage circuit in the laser emitting circuit in a second period of time, such that the energy storage circuit can supply power to the laser transmitter, such that the laser transmitter can emit a light pulse signal. The first period of time and the second period of time may alternate such that the laser transmitter can emit a laser pulse sequence. The transistor may be turned off and turned on alternately. When the transistor is turned off, the laser diode may not emit a light signal. When the transistor is turned on, a light pulse signal may be emitted, and the laser diode may emit a light pulse sequence.

In some embodiments, at least two laser emitting circuits may emit light pulse signals in different directions. The different directions referred to in the present disclosure may mean that the exit paths of the light pulses of the laser emitting circuits are not parallel.

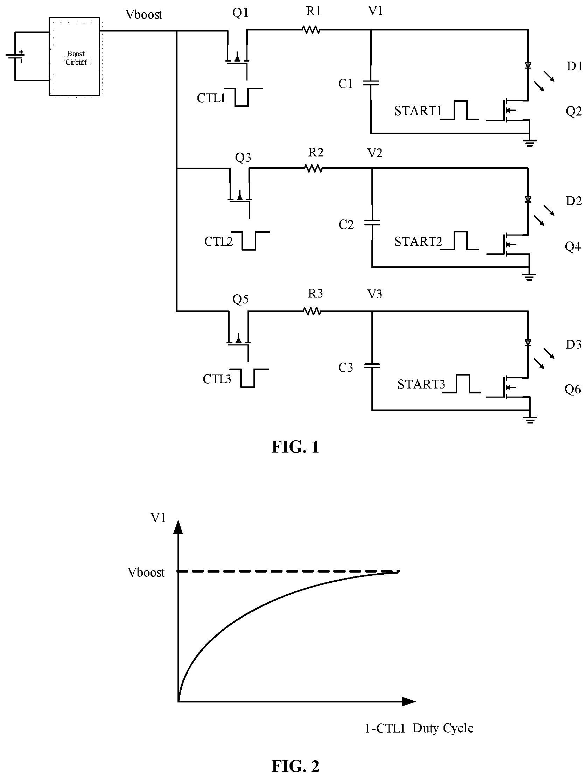

For example, a first laser emission solution of the present disclosure is shown in FIG. 1, where three laser emission circuits are used as an example. It should be noted that the technical solution of the present disclosure is not limited to three laser emission circuits.

In the schematic diagram of the first laser emission solution, a resistor R is mainly used to charge a capacitor C to store energy, and a light emitter D is excited to emit light when the capacitor C is discharged. Therefore, the signal emission energy of the light emitter may be determined by the energy stored in the capacitor C, where the energy of the capacitor C may be

$$E_C = \frac{1}{2}CU^2$$

In the above formula, EC is the electric energy of the capacitor, C is the capacitance value of the capacitor, and U is the voltage value across the capacitor. The capacitance value may represent the capacitance capacity of the capacitive device to a certain extent. When the capacitance of the capacitor is determined, controlling the voltage U of the capacitor C can control the stored energy of the capacitor C, thereby controlling the luminous energy of the laser. In order to detect longer distances, higher laser peak power is needed. However, safety regulations have limited the optical energy of a single pulse, therefore, the pulse width of the laser pulse may need to be further shortened. The smaller the capacitance value of the capacitor, the shorter the discharge time, and the narrower the pulse width of the light pulse. However, in order to ensure that the energy stored by the capacitor is large enough (but not exceeding the safety regulation value), then the voltage of the capacitor needs to be increased. Therefore, the operating voltage of the light emitter is generally relative high, so a boost circuit (including but not limited to a voltage boost, a charge pump boost, etc.) may be used first to increase the voltage to the operating voltage of the light emitter, and then the output voltage of the multi-channel power supply may be adjusted through the control voltage provided by a program (including but not limited to a DAC control or a PWM control), thereby realizing the adjustment of the multi-channel power supply.

The three laser emission circuits shown in FIG. 1 include a power supply, a boost circuit, a plurality of control circuits, a plurality of energy storage circuits, and a plurality of light emitters. The control circuit includes a plurality of first switch circuits and a plurality of second switch circuit. In some embodiments, each laser emission circuit may include a power supply, a boost circuit, a first switch circuit, a second switch circuit, and an energy storage circuit, where the energy storage circuit may include a resistor and a capacitor. The first laser emission circuit includes a power supply, a boost circuit, a first switch circuit Q1, a first resistor R1, a second circuit Q2, a first capacitor C1, and a first light emitter D1. The second laser emission circuit includes a power supply, a boost circuit, a first switch circuit Q3, a second resistor R2, a second switch circuit Q4, a second capacitor C2, and a second light emitter D2. The third laser emission circuit includes a power supply, a boost circuit, a first switch circuit Q5, a third resistor R3, a second switch circuit Q6, a third capacitor C3, and a third light emitter D3. Since different laser emission circuits include different resistors, capacitors, and control circuits, it is possible to achieve the effect of individual adjustment of different light emitters. Therefore, the optical energy of different light emitters can be calibrated, thereby compensating for the difference of each circuit, and realizing the first advantage of the present disclosure. In addition, through the control of different laser emission circuits, the multi-circuit light emitters can all meet the restriction of human eye safety. As shown in FIG. 1, the three laser emission circuits share the power supply and the boost circuit. Therefore, the components in the circuit can be reduced, thereby simplifying the circuit and reducing the hardware cost.

In the first laser emission circuit, a control signal CTL1 may control the on time of the first switch circuit Q1, thereby controlling the charging time of the boost circuit Vboost to the first capacitor C1 through the first resistor R1, and changing the duty circle of the control signal CTL1 to obtain different voltages V1. The first voltage V1 obtained by the first capacitor C1 will determine the luminous power of the first light emitter, thereby achieving the purpose of adjustable luminous power. In some embodiments, the relationship between the related quantity (1-CTL1) of the duty cycle of the control signal CTL1 and the voltage V1 across the first capacitor C1 is as shown in FIG. 2, whereas (1-CTL1) gradually increases, V1 on the first capacitor C1 gradually increases, thereby providing more energy for the first light emitter. That is, the luminous power of the light emitter can be controlled by the duty cycle of the control signal CTL1. Similarly, in the second laser emission circuit and the third laser emission circuit, the luminous power of the light emitters D2 and D3 can be controlled by controlling the duty cycles of the control signals CTL2 and CTL3, respectively, and its control principle is the same as that of the first laser emission circuit.

The timing relationship between the control signals CTLs and the light emitting signals STARTs of the three laser emission circuits is shown in FIG. 3. At time t0, the control signals CTL1, CTL2, and CTL3 of the three laser emission circuits are turned on at the same time, which means that the three laser emission circuits start charging at the same time to store energy in the energy storage circuits. In each circuit, the power supply charges the capacitor through the resistor. Respectively at times t1, t3, and t4, the first circuit, second circuit, and the third circuit of the laser emission circuits emit light in different times, and the next cycle starts at time t5. Specifically, at t0, the control signals CTL1, CTL2, and CTL3 simultaneously turn on the transistors Q1, Q3, and Q5, the power supply charges C1 through R2, C2 through R2, and C3 through R3. At time t1, the transistor Q2 is turned on, the capacitor C1 discharges the laser diode D1, and the laser diode D1 emits laser pulses. At time t3, the transistor Q4 is turned on, the capacitor C2 discharges the laser diode D2, and the laser diode D2 emits laser pulses. At time t5, the transistor Q6 is turned on, the capacitor C3 discharges the laser diode D3, and the laser diode D3 emits laser pulses. Therefore, under the control of the control circuit, the three laser emission circuits can emit laser pulses in sequence to realize the emission of the laser pulse sequence.

When the light emitter is working, the duty cycle is generally less than one thousands, that is, (t2-t1) < 1/1000. That is, in one cycle, the proportion of the time taken by the capacitor charging and the light emitter emitting light is small.

By adjusting the charging timing between the circuits, the timing diagram shown in FIG. 4 can be obtained.

Specifically, at time t0, the control signal CTL1 turns on the transistor Q1, and the power supply charges C1 through R1. At time t2, the control signal CTL2 turns on the transistor Q3, and the power supply charges C2 through R2. At time t4, the control signal CTL3 turns on the transistor Q5, and the power supply charges C3 through R3. At time t1, Q2 is turned on, the capacitor C1 discharges the laser diode D1, and the laser diode D1 emits laser pulses. At time t3, the transistor Q4 is turned on, the capacitor C2 discharges the laser diode D2, and the laser diode D2 emits laser pulses. At time t5, the transistor Q6 is turned on, the capacitor C3 discharges the laser diode D3, and the laser diode D3 emits laser pulses. Therefore, under the control of the control circuit, the three laser emission circuits can emit laser pulses in sequence to realize the emission of the laser pulse sequence.

Based on the aforementioned first laser emission solution, and duty cycle of the control signal of each laser emission circuit can be individually controlled. For example, the duty cycle of the control signals CTL1, CTL2, and CTL3 shown in FIG. 3 and FIG. 4 are different, such that the energy stored in the energy storage circuit of each laser emission circuit can be adjusted individually. Therefore, the present disclosure can realize the independent adjustment of laser emission power, and is suitable for products with multi-circuit laser emission. Through the individual adjustment of the multi-circuit laser emission, the calibration of the light energy of different light emitters can be realized, and the difference of each circuit can be compensated. Further, the multi-circuit light emitters can meet the safety regulations of human eyes, and because the multi-circuit laser emission share the power supply, the circuit is simplified and the hardware cost is reduced.

In some embodiments, CTL1, CTL2, and CTL3 in FIG. 3 may be combined by using the same CTL, such that the timing diagram can be simplified to the circuit timing diagram of FIG. 5. The charging pulse width at time t0 determines the voltage of D1 that emits light at time t1. Similarly, the charging pulse width at time t2 determines the voltage of D2 that emits light at time t3; and the charging pulse width at time t4 determines the voltage of D3 that emits light at time t5. As long as the pulse width is adjusted to match the voltage needed by the light emitter that will emit light at the next time, the voltage of each circuit can be individually controlled.

The circuit timing diagram shown in FIG. 5 corresponds to the schematic diagram of a second laser emission solution as shown in FIG. 6. The three laser emission circuits shown in FIG. 1 include a power supply, a boost circuit, a plurality of control circuits, a plurality of energy storage circuits, and a plurality of light emitters. The control circuit includes a plurality of first switch circuits and a plurality of second switch circuit. In some embodiments, each laser emission circuit may include a power supply, a boost circuit, a first switch circuit, a second switch circuit, and an energy storage circuit, where the energy storage circuit may include a resistor and a capacitor. The first laser emission circuit includes a power supply, a boost circuit, a first switch circuit Q1, a first resistor R1, a second circuit Q2, a first capacitor C1, and a first light emitter D1. The second laser emission circuit includes a power supply, a boost circuit, a first switch circuit Q1, a second resistor R1, a second switch circuit Q4, a second capacitor C1, and a second light emitter D2. The third laser emission circuit includes a power supply, a boost circuit, a first switch circuit Q1, a third resistor R1, a second switch circuit Q5, a third capacitor C1, and a third light emitter D3.

In the first laser emission circuit, the control signal CTL may control the on time of the first switch circuit Q1, thereby controlling the charging time of the boost circuit Vboost to the first capacitor C1 through the first resistor R1, and the changing the duty cycle of the control signal CTL to obtain different voltage V1. The voltage V1 obtained by the first capacitor C1 will determined the luminous power of the first light emitter D1, thereby achieving the purpose of adjustable luminous power. The relationship between the duty cycle of the control signal (1-CTL) and the voltage V1 across the first capacitor C1 is shown in FIG. 2. In some embodiments, as the duty cycle of the control signal (1-CTL) gradually increases, V1 on the first capacitor C1 gradually increases, thereby providing more energy for the first light emitter. Similarly, in the second laser emission circuit and the third laser emission circuit, the luminous power of the light emitters D2 and D3 can be controlled by controlling the duty cycles of the control signal CTL, and its control principle is the same as that of the first laser emission circuit.

Specifically, at time t0, the control signal CTL turns on the transistor Q1, and the power supply charges C1 through R1. At time t2, the control signal CTL turns on the transistor Q1, and the power supply charges C1 through R1. At time t4, the control signal CTL turns on the transistor Q1, and the power supply charges C1 through R1. At time t1, Q2 is turned on, the capacitor C1 discharges the laser diode D1, and the laser diode D1 emits laser pulses. At time t3, the transistor Q4 is turned on, the capacitor C1 discharges the laser diode D2, and the laser diode D2 emits laser pulses. At time t5, the transistor Q5 is turned on, the capacitor C1 discharges the laser diode D3, and the laser diode D3 emits laser pulses. Therefore, under the control of the control circuit, the three laser emission circuits can emit laser pulses in sequence to realize the emission of the laser pulse sequence.

Since the pulse widths of the control signal CTL at times t0, t2, and t4 are different, the charge to the C1 may be different in different periods of time. Therefore, when the first emission circuit, the second emission circuit, and the third emission circuit are turned on at times t1, t3, and t5 respectively, the discharge capacity of the capacitors D1, D2, and D3 may be different, and the output energy of the laser diode in different laser emission circuits may be controlled by controlling the pulse width of the control signal CTL at times t0, t2, and t4, thereby individually adjusting the energy stored in the energy storage circuit of each laser emission circuit. Therefore, the present disclosure can realize the independent adjustment of laser emission power, and is suitable for products with multi-circuit laser emission. Through the individual adjustment of the multi-circuit laser emission, the calibration of the light energy of different light emitters can be realized, and the difference of each circuit can be compensated. Further, the light emitters of the multi-circuit light emitters can all meet the safety regulations of human eyes, and because the multi-circuit laser emission share the power supply, the first switch circuit and the energy storage circuit, the circuit is significantly simplified and the hardware cost is reduced.

Therefore, compared with the first laser emission solution, the first switch Q1, the energy storage circuit R1 and C1 are reused in the aforementioned second laser emission solution, which not only realizes the voltages of D1, D2, and D3 to be individually adjustable, it further reduces the number of components and the number of control signals, and reduces hardware costs.

A third laser emission solution of the present disclosure is shown in FIG. 7 (which takes three circuits as an example, but is not limited to three circuits).

As shown in FIG. 7, the three laser emission circuits includes a power supply, a plurality of control circuits, a plurality of energy storage circuit, and a plurality of light emitters. Each control circuit may include a first switch circuit and a second switch circuit. In some embodiments, each laser emission circuit may include a power supply, a first switch circuit, a second switch circuit, and an energy storage circuit, where the energy storage circuit may include an inductor, a diode, and a capacitor. The first laser emission circuit includes a power supply, a first switch circuit Q1, a first inductor L1, a diode D1, a second switch circuit Q2, a first capacitor C1, and a first light emitter D2. The second laser emission circuit includes a power supply, a first switch circuit Q3, a second inductor L2, a diode D3, a second switch circuit Q4, a second capacitor C2, and a second light emitter D4. The third laser emission circuit includes a power supply, a first switch circuit Q5, a third inductor L3, a diode D5, a second switch circuit Q6, a third capacitor C3, and a third light emitter D6. Since different laser emission circuit includes different inductors, diodes, capacitors, and control circuits, it is possible to achieve the effect of individual adjustment of different light emitters. Therefore, the light energy of different light emitters can be calibrated to compensate for the difference of each circuit. In addition, by controlling the different laser emission circuits, the light emitters of the multi-circuit light emitters can meet the safety regulations of human eyes. As shown in FIG. 7, the three laser emission circuits share the power supply, therefore the components in the circuit can be reduced, thereby realizing the technical effect of simplifying the circuit and reducing the hardware cost.

The implementation may be as follow. Compared with passing a low voltage through the boost circuit to obtain a higher voltage, and then use the inductor L to charge the capacitor C, the circuit may directly use a lower voltage V, and charge the inductor with different energy values through the conduction time of the first switch circuit with different widths. When the first switch circuit is closed, the inductor may charge the energy into the capacitor through the diode, and the second switch circuit corresponding to the light emitter may be turned on at the next time after the charging is completed. That is, the MOS may be controlled, and the corresponding light emitting can emit light.

In the first laser emission circuit, the control signal CTL1 may control the on time or off time of the first switch circuit Q1. The charging time of the first inductor L1 and the diode D1 to the first capacitor C1, the luminous power of the light emitter D2 can be controlled by the duty cycle of the control signal CTL1. Similarly, in the second laser emission circuit and the third laser emission circuit, the luminous power of the light emitters D4 and D6 can be controlled by controlling the duty cycles of the control signals CTL2 and CTL3, respectively, and its control principle is the same as that of the first laser emission circuit.

A fourth laser emission solution of the present disclosure is as shown in FIG. 8. The three laser emission circuits includes a power supply, a plurality of control circuits, an energy storage circuit, and a plurality of light emitters, and the control circuit includes a plurality of first switch circuit and a plurality of second switch circuit. In some embodiments, each laser emission circuit may include a power supply, a first switch circuit, a second switch circuit, and an energy storage circuit. The energy storage circuit may include an inductor, a diode, and a capacitor. The first laser emission circuit may include a power supply, a first switch circuit Q1, a first inductor L1, a second switch circuit Q2, a first capacitor C1, and a first light emitter D2. The second laser emission circuit includes a power supply, a first switch circuit Q1, a second inductor L1, a second switch circuit Q4, a second capacitor C2, and a second light emitter D4. The third laser emission circuit includes a power supply, a first switch circuit Q1, a third inductor L1, a second switch circuit Q6, a third capacitor C1, and a third light emitter D6.

Therefore, compared with the third laser emission solution, the foregoing fourth laser emission solution also reuses the energy storage circuit, the first switch and the energy storage, where the energy storage circuit includes an inductor, a diode, and a capacitor. Therefore, by reusing the first switch circuit Q1, the energy storage circuit L1, D1, and C1 not only realizes independent adjustment of the voltages of D2, D4, and D6, it further reduces the number of components and the number of control signals, and reduces hardware costs.

In the fourth laser emission solution, a schematic diagram of the inductive charging loop is shown in FIG. 9. When the first switch circuit Q1 is turned on, the power supply starts to charge the inductor L1, and the control signal CTL controls the conduction time of the first switch circuit Q1 to obtain different currents i. The relationship between the duty cycle of the control signal CTL and the voltage i obtained by the first inductor L1 is shown in FIG. 10, whereas the duty cycle of the control signal CTL gradually increases, the current i on the first inductor L1 gradually increases, thereby providing more energy for the first light emitter. That is, the luminous power of the light emitter can be controlled by the duty cycle of the control signal CTL. Similarly, in the second laser emission circuit and the third laser emission circuit, the luminous power of the light emitters D4 and D6 can be controlled by controlling the duty cycles of the control signal CTL, and its control principle is the same as that of the first laser emission circuit.

In the fourth laser emission solution, a schematic diagram of the inductor being a capacitor charging loop is shown in FIG. 11. When the first switch circuit Q1 is turned off, determined by the characteristics of the inductor, the current therein cannot undergo abrupt changes, therefore, the inductor L1 will charge the capacitor C1 through the diode D1, and the charging path is shown in the arrow in FIG. 11. The charging process of the three laser emission circuits is similar, and they may all be performed through the inductor charging path and the inductor charging path shown in FIG. 9 and FIG. 11.

In the fourth laser emission solution, a schematic diagram of the discharge loop of a first light emitting element and a first light reflector D2 is as shown in FIG.

12. When the second switch circuit Q1 is turned on, the capacitor C1 discharges the light emitter D2, and the discharge path is shown by the arrow in FIG. 12. Due to the existence of the diode D1, the capacitor C1 will not reversely charge the inductor L1. Therefore, the electrical energy on the capacitor C1 can only be released along the illustrated loop, such that the light emitter D2 can emit light. The second laser emission circuit can be controlled by the second switch circuit Q4 to realize the light pulse emission of the light emitter D4. The third laser emission circuit can be controlled by the second switch circuit Q6 to realize the light pulse emission of the light emitter D6.

The control sequence of the fourth laser emission solution is as shown in FIG. 13. In the first laser emission circuit, the control signal CTL controls the conduction time of the first switch circuit Q1. During the conduction time, the power supply charges the inductor, controls the electrical energy stored in the inductor by controlling the duty cycle of the control signal CTL, and finally converts it into the luminous power of the light emitter D2. Similarly, in the second laser emission circuit and the third laser emission circuit, the luminous power of the light emitters D4 and D6 can be controlled by controlling the duty cycles of the control signal CTL, and its control principle is the same as that of the first laser emission circuit.

Specifically, at time t0, the control signal CTL turns on the transistor Q1, and the power supply charges the inductor L1. At time t2, the control signal CTL turns on the transistor Q1, and the power supply charges the inductor L1. At time t4, the control signal CTL turns on the transistor Q1, and the power supply charges the inductor L1. The above realizes the charging of part of the energy storage circuits of the three laser emission circuits. This period of time is constituted as a third period of time, which constitutes part of a first period of time. In the third period of time, a first loop may be turned on. The first loop may include the power supply and the inductor connected in series, and the power supply may be used to charge the inductor. After the CTL turns off the transistor Q1 and before the time t1, the inductor L1 can charge the capacitor. This period of time is the fourth period of time, which is part of the first period of time. In the fourth period of time, a second loop may be turned on. The second loop may include the inductor and the capacitor connected in series. The inductor may be used to charge the capacitor. After the charging process, a discharge process will follow. For example, at the time t1, the transistor Q2 may be turned on, the capacitor C1 may discharge the laser diode D2, and the laser diode D2 may emit laser pulses. At time t3, the transistor Q4 may be turned on, capacitor C1 may discharge the laser diode D4, and the laser diode D4 may emit laser pulses. At time t5, the transistor Q6 may be turned on, the capacitor C1 may discharge the laser diode D6, the laser diode D6 may emit laser pulses, and the discharge process is the second period of time. The control circuit may conduct the laser emitter and the energy storage circuit in the laser emission circuit in the second period of time, such that the energy storage circuit can supply power to the laser emitter, such that the laser emitter can emit a light pulse signal. Therefore, under the control of the control circuit, the three laser emission circuits can emit laser pulses in sequence to achieve the emission of laser pulse sequence, where the third period of time and the second period of time at least partially overlap.

Since the pulse widths of the control signal CTL at times t0, t2, and t4 are different, the charge to the C1 may be different in different periods of time. Therefore, when the first emission circuit, the second emission circuit, and the third emission circuit are turned on at times t1, t3, and t5 respectively, the discharge capacity of the capacitors D2, D4, and D6 may be different, and the output energy of the laser diode in different laser emission circuits may be controlled by controlling the pulse width of the control signal CTL at times t0, t2, and t4, thereby individually adjusting the energy stored in the energy storage circuit of each laser emission circuit. Therefore, the present disclosure can realize the independent adjustment of laser emission power, and is suitable for products with multi-circuit laser emission. Through the individual adjustment of the multi-circuit laser emission, the calibration of the light energy of different light emitters can be realized, and the difference of each circuit can be compensated. Further, the light emitters of the multi-circuit light emitters can all meet the safety regulations of human eyes, and because the multi-circuit laser emission share the power supply, the first switch circuit and the energy storage circuit, the circuit is significantly simplified and the hardware cost is reduced.

Therefore, compared with the first laser emission solution, the foregoing fourth laser emission solution reuses the first switch Q1, the energy storage circuit L1, D1, and C1, which not only realizes the voltages of D2, D4, and D6 to be individually adjustable, it further reduces the number of components and the number of control signals, and reduces hardware costs.

A fifth laser emission solution of the present disclosure is shown in FIG. 14 (three circuits are taken as an example, but is not limited to three circuits). As shown in FIG. 14, the three laser emission circuits includes a power supply, a plurality of control circuits, a plurality of energy storage circuits, and a plurality of light emitters. The control circuit may include a plurality of first switch circuits and a plurality of second switch circuits. In some embodiments, each laser emission circuit may include a power supply, a first switch circuit, a second switch circuit, and an energy storage circuit, where the energy storage circuit may include an inductor, a diode, and a capacitor. The first laser emission circuit includes a power supply, a first switch circuit Q2, a first inductor L1, a diode D1, a second switch circuit Q2, a first capacitor C1, and a first light emitter D2. The second laser emission circuit includes a power supply, a first switch circuit Q4, a second inductor L2, a diode D3, a second switch circuit Q4, a second capacitor C2, and a second light emitter D4. The third laser emission circuit includes a power supply, a first switch circuit Q6, a third inductor L3, a diode D4, a second switch circuit Q6, a third capacitor C3, and a third light emitter D6. Since different laser emission circuits include different inductors, diodes, capacitors, and control circuits, it is possible to achieve the effect of individual adjustment of different light emitters. Therefore, the optical energy of different light emitters can be calibrated, thereby compensating for the difference of each circuit, and realizing the first advantage of the present disclosure. In addition, through the control of different laser emission circuits, the multi-circuit light emitters can all meet the restriction of human eye safety. As shown in FIG. 14, the three laser emission circuits share the power supply, therefore, the components in the circuit can be reduced, thereby realizing the technical effect of simplifying the circuit and reducing the hardware cost. In addition, inside each laser emission circuit, the first switch circuit and the second switch circuit have the same transistor, which reuses the MOS transistor, thereby further reducing the complexity of the design, reducing the number of components and control signals, and reducing the hardware cost.

A sixth laser emission solution of the present disclosure is shown in FIG. 15. The three laser emission circuits include a power supply, a control circuit, an energy storage circuit, and a plurality of light emitters. The control circuit may include a first switch circuit and a second switch circuit, and the first switch circuit and second switch circuit may reuse a transistor. In some embodiments, each laser emission circuit may include a power supply, a first switch circuit, a second switch circuit, and an energy storage circuit, where the energy storage circuit may include an inductor, a diode, and a capacitor. The first laser emission circuit includes a power supply, a first switch circuit Q2, a first inductor L1, a diode D1, a second switch circuit Q2, a first capacitor C1, and a first light emitter D2. The second laser emission circuit includes a power supply, a first switch circuit Q4, a second inductor L1, a diode D1, a second switch circuit Q4, a second capacitor C1, and a second light emitter D4. The third laser emission circuit includes a power supply, a first switch circuit Q6, a third inductor L1, a diode D1, a second switch circuit Q6, a third capacitor C1, and a third light emitter D6.

Therefore, compared with the fifth laser emission solution, in the foregoing sixth laser emission solution, the first switch circuit and the second switch circuit are reused and implemented by using a single switch circuit. Further, the power supply and the energy storage circuit are reused, where the energy storage circuit includes an inductor, a diode, and a capacitor. Therefore, the inductor L1, the diode D1, and the capacitor C1 are reused, which not only realizes the independent adjustment of the voltages of D2, D4, and D6, it further reduces the number of components and the number of control signals, and reduces hardware costs.

In the sixth laser emission solution, a schematic diagram of the charging path and the discharging path in shown in FIG. 16. Take the first laser emission circuit as an example, in the second period of time, a third loop may be turned on, and the capacitor and the laser emitter may be turned on. When Q2 is turned on, that is, the second switch circuit is turned on, the energy in the capacitor C1 may drive the light emitter D2 to emit light. This process can be completed within a few nanoseconds. The current path is shown by the smaller arrow in FIG. 16. After the energy of the capacitor C1 is discharged, if the transistor Q2 is not turned off, the light emitter D2 and the transistor Q2 may be in a short-circuit state to the ground. At this time, the power supply may charge the inductor L1 through this path. The current path is shown by the larger arrow in FIG. 16, and this is the third period of time. In the third period of time, the first loop may be turned on. The first loop may include a power supply and an inductor L1 connected in series. At this time, since the transistor Q2 is still in the one state, the third period of time will partially overlap with the foregoing second period of time, and in the third period of time, the power supply may charge the inductor. Therefore, the third period of time belongs to a part of the first period of time. In this way, by controlling the off time of Q2, the energy needed to charge the inductor for the next light emitter to emit light can be controlled, thereby controlling the capacitor voltage. In addition, when the transistor Q2 is turned off, it is the fourth period of time. In the fourth period of time, the second loop may still be turned on, and the second loop may include the inductor and the capacitor connected in series. The inductor may be used to charge the capacitor, and the fourth period of time may also be a part of the first period of time. The third period of time and the fourth period of time may constitute the first period of time, which can realize the process of charging the capacitor by the power supply.

The control sequence of the sixth laser emission solution is shown in FIG. 17. In the first laser emission circuit, the control signal START1 may control the conduction time of the transistor Q2. The light emitter D2 may emit light at time t0. The time interval between the time t0 and the time t1 may determine the energy charged to the inductor L1, which determines the amount of energy emitted by the light emitter D4 at time t2; and the time interval between the time t2 and the time t3 may determine the energy charged to the inductor L1, which determines the amount of energy that the light emitter D6 emits at the time t4. The process can be sequentially repeated to emit a light pulse sequence.

Specifically, at time t0, the control signal START1 may turn on the transistor Q2, the light emitter D2 may emit light to emit light pulses, and the power supply may charge the inductor L1. At time t1, the process of charging the inductor by the power supply may end, where the time interval between the time t0 and the time t1 may determine the energy charged to the inductor L1. At time t1, the inductor L1 may charge the capacitor C1. In the time interval between the time t1 and the time t2, the inductor L1 may charge the capacitor C2. At time t2, the control signal START2 may turn on the transistor Q4, the light emitter D4 may emit light to emit light pulses, and the energy of the light pulses emitted by the light emitter D4 may depend on the electrical energy stored in the capacitor C1, and therefore may depend on the time interval between the time t0 and the time t1. Further, in the time interval between the time t2 to the time t3, C1 may be charged again through the inductor L1. Starting at time t3, the inductor L1 may charge the capacitor C1. In the time interval between the time t3 and the time t4, the inductor L1 may charge the capacitor C1 at t4. At time t4, the control signal START3 may turn on the transistor Q6, the light emitter D6 may emit light to emit light pulses, and the energy of the light pulses emitted by the light emitter D6 may depend on the electrical energy stored in the capacitor C1, and therefore may depend on the time interval between the time t2 and the time t3. In the time interval between the time t3 and the time t4, C1 may be charged again through the inductor L1 to prepare for the next light emission of the light emitter D2. The process can be sequentially repeated to emit a light pulse sequence.

Since the pulse widths of the control signal CTL at times t0, t2, and t4 are different, the charge to the C1 may be different in different periods of time. Therefore, when the first emission circuit, the second emission circuit, and the third emission circuit are turned on at times t1, t3, and t5 respectively, the discharge capacity of the capacitors D2, D4, and D6 may be different, and the output energy of the laser diode in different laser emission circuits may be controlled by controlling the pulse width of the control signal CTL at times t0, t2, and t4, thereby individually adjusting the energy stored in the energy storage circuit of each laser emission circuit. Therefore, the present disclosure can realize the independent adjustment of laser emission power, and is suitable for products with multi-circuit laser emission. Through the individual adjustment of the multi-circuit laser emission, the calibration of the light energy of different light emitters can be realized, and the difference of each circuit can be compensated. Further, the multi-circuit light emitters can meet the safety regulations of human eyes, and because the multi-circuit laser emission share the power supply, the first switch circuit, and the energy storage circuit, the circuit is simplified and the hardware cost is reduced.

Therefore, compared with the fifth laser emission solution, in the foregoing sixth laser emission solution, the D1, L1, and C1 are reused, which not only realizes the independent adjustment of the voltages of D2, D4, and D6, it further reduces the number of components and the number of control signals, and reduces hardware costs.

A seventh laser emission solution of the present disclosure is shown in FIG. 18 (which takes three circuits as an example, but is not limited to three circuits). As shown in FIG. 18, the three laser emission circuits include a power supply, a plurality of control circuits, a plurality of energy storage circuits, a plurality of diodes, and a plurality of light emitters. The control circuit may include a plurality of first switch circuits and a plurality of second switch circuits. In some embodiments, each laser emission circuit may include a power supply, a first switch circuit, a second switch circuit, and an energy storage circuit, where the energy storage circuit may include an inductor, a diode, and a capacitor. The first laser emission circuit includes a power supply, a first switch circuit Q1, a first inductor L1, a diode D1, a second switch circuit Q1, a first capacitor C1, a first light emitter D3, and a diode D2 connected in anti-parallel to both ends of the light emitter D3. The second laser emission circuit includes a power supply, a first switch circuit Q2, a second inductor L2, a diode D4, a second switch circuit Q2, a second capacitor C2, a second light emitter D6, and a diode D5 connected in anti-parallel to both ends of the light emitter D6. The third laser emission circuit includes a power supply, a first switch circuit Q3, a third inductor L3, a diode D7, a second switch circuit Q3, a third capacitor C3, a third light emitter D9, and a diode D8 connected in anti-parallel to both ends of the light emitter D9. Since different laser emission circuits include different inductors, diodes, capacitors, and control circuits, it is possible to achieve the effect of individual adjustment of different light emitters. Therefore, the optical energy of different light emitters can be calibrated, thereby compensating for the difference of each circuit, and realizing the first advantage of the present disclosure. In addition, through the control of different laser emission circuits, the multi-circuit light emitters can all meet the restriction of human eye safety. As shown in FIG. 18, the three laser emission circuits share the power supply, therefore, the components in the circuit can be reduced, thereby realizing the technical effect of simplifying the circuit and reducing the hardware cost. In addition, inside each laser emission circuit, the first switch circuit and the second switch circuit have the same transistor, which reuses the MOS transistor, thereby further reducing the complexity of the design, reducing the number of components and control signals, and reducing the hardware cost.

The sixth laser emission solution of the present disclosure is shown in FIG. 19, where the three laser emission circuits include a power supply, a plurality of control circuits, a plurality of energy storage circuits, and a plurality of diodes, and a plurality of light emitters. The control circuit may include a first switch circuit and a second switch circuit, and the first switch circuit and second switch circuit may reuse a transistor. In some embodiments, each laser emission circuit may include a power supply, a first switch circuit, a second switch circuit, an energy storage circuit, and a diode, where the energy storage circuit may include an inductor, a diode, and a capacitor. The first laser emitting circuit includes a power supply, a first switch circuit Q1, a first inductor L1, a diode D1, a second switch circuit Q1, a first capacitor C1, a first light emitter D3, and a diode D2 connected in anti-parallel to both ends of the light emitter D3. The second laser emitting circuit includes a power supply, a first switch circuit Q2, a second inductor L1, a diode D4, a second switch circuit Q2, a second capacitor C1, a second light emitter D6, and a diode D5 connected in anti-parallel to both ends of the light emitter D6. The third laser emitting circuit includes a power supply, a first switch circuit Q3, a third inductor L1, a diode D7, a second switch circuit Q3, a third capacitor C1, a third light emitter D9, and a diode D8 connected in anti-parallel to both ends of the light emitter D9.

Therefore, compared with the seventh laser emission solution, in the foregoing eighth laser emission solution, not only the first switch circuits and the second switch circuits are reused, but also a part of the energy storage circuit, including the inductors and the capacitors are reused. Therefore, the inductor L1 and the capacitor C1 are reused, which not only realizes the independent adjustment of the voltages of D3, D6, and D9, it further reduces the number of components and the number of control signals, and reduces hardware costs.

In the eighth laser emission solution, a schematic diagram of the charging path and the discharging path are shown in FIG. 20. Take the first laser emission circuit as an example, in the second period of time, the third loop may be turned on, and the capacitor and the laser emitter may be turned on. When Q1 is turned on, the second switch circuit may be turned on, the energy in the capacitor C1 may drive the light emitter D3 to emit light. This process can be completed within a few nanoseconds, and the current path is shown by the smaller arrow on the inner right side in FIG. 20. After the energy of the capacitor C1 is discharged, if the transistor Q2 is not turned off, the light emitter D2 and the transistor Q2 may be in a short-circuit state to the ground. At this time, the power supply can charge the inductor L1 through this path. The current path is shown by the smaller arrow on the left side in FIG. 20. The power supply can charge L1 through the inductor L1, diode D1, and Q1 path, which is the third period of time. In the third period of time, the first loop may be turned on, and the first loop may include a power supply and an inductor L1 connected in series. At this time, since the transistor Q2 may still be in the on state, the third period of time may partially overlap with the aforementioned second period of time, and during the third period of time, the power supply can charge the inductor. Therefore, the third period of time may belong to a part of the first period of time. In this way, by controlling the off time of the Q1, the energy needed to charge the inductor for the next light emitter may be controlled to control the capacitor voltage. In addition, when the transistor Q1 is turned off, it is the fourth period of time. In the fourth period of time, the second loop may still be turned on. The second loop may include the inductor, the diode D1, and the diode D2, and the capacitor connected in series, and the inductor may be used to charge the capacitor. The fourth period of time may also be a part of the first period of time. The third period of time and the fourth period of time may constitute the first period of time, which can realize the process of charging the capacitor by the power supply. The charging path is shown by the larger arrow on the outside in FIG. 20.

The control sequence of the eighth laser emission solution is shown in FIG. 21. In the first laser emission circuit, the control signal START1 may control the conduction time of the transistor Q1. The light emitter D3 may emit light at time t0. The time interval between the time t0 and the time t1, which may determine the amount of energy emitted by the light emitter D6 at time t2. The time interval between the time t2 and the time t3 may determine the energy charged to the inductor L1, which may determine the amount of energy that the light emitter D9 emits at time t4. The process can be sequentially repeated to emit a light pulse sequence.

Specifically, at time t0, the control signal START1 may turn on the transistor Q1, the light emitter D3 may emit light, and the power supply may charge the inductor L1. At time t1, the process of charging the inductor by the power supply ends. The time interval between the time t0 and the time t1 may determine the energy charged to the inductor L1. Starting at the time t1, the inductor L1 may charge the capacitor C1. In the time interval between the time t1 and the time t2, the inductor C1 may charge the capacitor at t2. At time t2, the control signal START2 may turn on the transistor Q2, the light emitter D6 may emit light to emit light pulses. The energy of the light pulses emitted by the light emitter D6 may depend on the electrical energy stored in the capacitor C1, and therefore may depend on the time interval between t0 to t1, and in the time interval between t2 to t3, C1 may be charged again through the inductor L1. Starting at time t3, the inductor L1 may charge the capacitor C1. In the time interval between t3 and t4, the inductor L1 may charge the capacitor at t4. At time t4, the control signal START3 may turn on the transistor Q9, the light emitter D9 may emit light to emit light pulses. The energy of the light pulses emitted by the light emitted D6 may depend on the electrical energy stored in the capacitor C1, and therefore may depend on the time interval between t2 and t3. In the time interval between t3 and t4, C1 may be charged again through the inductor L1 to prepare for the next light emission of the light emitter D3. The process can be sequentially repeated to emit a light pulse sequence.

Since the pulse widths of the control signal CTL at times t0, t2, and t4 are different, the charge to the C1 may be different in different periods of time. Therefore, when the first emission circuit, the second emission circuit, and the third emission circuit are turned on at times t1, t3, and t5 respectively, the discharge capacity of the capacitors D3, D6, and D9 may be different, and the output energy of the laser diode in different laser emission circuits may be controlled by controlling the pulse width of the control signal CTL at times t0, t2, and t4, thereby individually adjusting the energy stored in the energy storage circuit of each laser emission circuit. Therefore, the present disclosure can realize the independent adjustment of laser emission power, and is suitable for products with multi-circuit laser emission. Through the individual adjustment of the multi-circuit laser emission, the calibration of the light energy of different light emitters can be realized, and the difference of each circuit can be compensated. Further, the multi-circuit light emitters can meet the safety regulations of human eyes, and because the multi-circuit laser emission share the power supply, the first switch circuit, and the energy storage circuit, the circuit is simplified and the hardware cost is reduced.

Therefore, compared with the seventh laser emission solution, in the foregoing eighth laser emission solution, the inductor L1 and the capacitor C1 are reused, which not only realizes the independent adjustment of the voltages of D3, D6, and D9, it further reduces the number of components and the number of control signals, and reduces hardware costs.

In the seventh laser emission solution and the eighth laser emission solution, a diode is connected in anti-parallel at both ends of the light emitter of each laser emission circuit. The diode ensures the unidirectional conduction of the current, and can only charge the capacitor by the inductor, and will not cause the reverse charging of the capacitor to the inductor. In addition, the diode ensures that the electrical energy of the capacitor can only pass through the path of the light emitter during the light emission process of the light emitter, and ensures the generation of the light pulses.

FIG. 24 is a schematic diagram of a ninth laser emission solution according to an embodiment of the present disclosure, and FIG. 25 is a schematic diagram of the charging path and the discharging path in the ninth laser emission solution according to an embodiment of the present disclosure. This embodiment is similar to the sixth embodiment. In the ninth laser emission solution, the switch type in the sixth laser emission solution is replaced. For example, the NMOS control switch may be replaced with the PMOS control switch. The specific connection method is shown in FIG. 24, and the corresponding charging path and discharging path are shown as the circular lines in FIG. 25.

In some embodiments, in order to further meet the requirements of laser safety regulations (e.g., when a single component fails, the laser emission power cannot exceed the safety value), a reset circuit may be added to each laser emission circuit, which can be used to reset the energy storage circuit in the laser emission circuit based on the control signal. For example, the reset circuit can be used to reset the energy stored in the energy storage circuit in the laser emission circuit to zero or restore to an initial value based on the control signal. In one example, the energy storage circuit may include a capacitor, one end of the capacitor may be grounded, one end of the reset circuit may be connected to the other end of the capacitor, and the other end of the reset circuit may be grounded. The reset circuit may include a switch circuit. When the switch circuit is turned on, both ends of the capacitor may be grounded, such that the stored energy on the capacitor can be released. In one example, the reset circuit may further includes a resistor connected in series with the switch circuit.

In the solutions that each laser emission circuit shares the energy storage circuit, the shared energy storage circuit can only use one reset circuit. FIG. 26 is a schematic diagram of the charging path and the discharging path in a tenth laser emission solution according to an embodiment of the present disclosure, and FIG. 27 is a schematic diagram of the control sequence of the tenth laser emission solution according to an embodiment of the present disclosure. This embodiment is similar to the eighth embodiment. In the tenth laser emission solution, based on the eighth laser emission solution, a reset circuit is added, and the reset circuit includes a switch circuit. For example, the switch circuit is a transistor Q4, which can be used to discharge and reset the capacitor after each laser light emission based on a reset signal RESET to ensure that the entire system is in a zero state during the next charge. The tenth laser emission solution will be described below in conjunction with the timing diagram shown in FIG. 27.

The timing diagram is shown in FIG. 27. At time t0, START1 may turn on Q1 and the power supply may charge the inductor L1. The charging loop is shown in the inner left loop. The capacitor C1 may drive the laser diode D3 to emit light. The driving loop is as shown in the inner right loop. The light emitting time of the laser diode D3 may be between t0 and t1. At time t1, RESET may turn on Q4, and discharge and reset C1. The discharge and reset loop is shown in the right loop (to prevent D3 from being open when C1 does not drive D3 to emit light between t0 to t1), and t1 to t2 being the discharge and reset time of C1. At time t2, the RESET signal may turn off Q4 to prepare for the next charge of the capacitor. At time t3, the START1 signal may turn off Q1. The inductor may charge C1 through D1, and its charging loop is shown in the outer left loop. t4 to t7 is the process of the second circuit D6 laser emitter emitting, resetting, and charging. t8 to t11 is the process of the third circuit D9 laser emitter emitting, resetting, and charging. At this point, a cycle is completed. At time t12, the next cycle may start from the first circuit D3 again, and the process can be repeated.

Combining the various embodiments above, the following description is provided.

In some embodiments, in at least two laser emission circuits, a laser emitter in each laser emission circuit may be used to emit a light pulse sequence, and the at least two laser emission circuits may alternately emit a light pulse sequence. For example, in the embodiment shown in FIG. 1, three laser emission circuits are included. Based on the control sequence diagrams provided in FIG. 3 and FIG. 4, each laser emitter in the embodiment shown in FIG. 1 can be used for emitting pulse sequences, and in the three laser emission circuits, light pulse sequences may be alternately emitted. In other embodiments, the function of alternately emitting light pulse sequence described above can all be realized.

In some embodiments, between the two adjacent laser emission circuits of the at least two laser emission circuit emitting light pulse signals, the remaining laser emission circuit of the at least two laser emission circuits may respectively emit one light pulse signal in sequence. For example, in the embodiment shown in FIG. 1, three laser emission circuits are included. Based on the control sequence diagrams provided in FIG. 3 and FIG. 4, in the embodiment shown in FIG. 1, each laser emitter may be used to emit a pulse sequence, and in the three laser emission circuits, the light pulse sequence may be alternately emitted. After the first laser emission circuit emits a pulse, the second and third emission circuits may emit a light pulse in turn, and the first laser emission circuit may emit a pulse again in the next cycle. It can be seen that between the two emissions of the light pulse signals of the first laser emission circuit, the second laser emission circuit and the third laser emission circuit each emits a pulse signal in turn. In other embodiments, the function of alternately emitting light pulse sequence described above can all be realized.

In some embodiments, the two or more laser emission circuits share at least part of the control circuit. For example, in the embodiment shown in FIG. 6, the three laser emission circuits share Q1 in the control circuit.

In some embodiments, the control circuit may control the laser emission circuit in different periods of time, and realize the output of light signals of the laser emitters in the different laser emission circuits in different periods of time. For example, in the embodiment shown in FIG. 6, the three laser emission circuits share Q1 in the control circuit, and in different periods of time, different laser emission circuits can be turned on. Inside each laser emission circuit, Q2, Q4, and Q6 can respectively control the on time, such that different laser emission circuit can emit light signals.

In some embodiments, the control circuit may include a first switch circuit and a second switch circuit. In each of the laser emission circuit, the first switch circuit may be used to turn on and off the connection between the power supply and the energy storage circuit of the laser emission circuit based on the drive signal. The second switch circuit may be used to turn on and off the connection between the energy storage circuit and the laser emitter based on the drive signal. For example, in the embodiment shown in FIG. 6, three laser emission circuits share Q1 in the control circuit. The first laser emission circuit includes a first switch circuit Q1 and a second switch circuit Q2, the laser emission circuit includes the first switch circuit Q1 and a second switch circuit Q4, and the third laser emission circuit includes the first switch circuit Q1 and a second switch circuit Q6. Based on the connection shown in FIG. 6, the first switch circuit Q1 can turn on and off the connection between the power supply and the energy storage circuit L1 and C1 based on the drive signal, and the second switch circuits Q2, Q4, and Q6 can turn on and off the connection between C1 and D1, D2, and D3 based on the drive signal.

In some embodiments, the at least two laser emission circuits may share the first switch circuit and/or the second switch circuit. For example, in the embodiment shown in FIG. 6, the three laser emission circuits share the first switch circuit Q1 in the control circuit. In the embodiment shown in FIG. 18, the first laser emission circuit shares the first switch circuit and the second switch circuit, which is embodied as a switch Q1.

In some embodiments, the first switch circuit may be used to control the on and off of the energy storage circuit in different laser emission circuits and the power supply in different periods of time based on the drive signal; and/or, the second switch circuit may be used to control the on and off of the energy storage circuit in different laser emission circuits and the laser emitter in different periods of time based on the drive signal. For example, in the embodiment shown in FIG. 6, the three laser emission circuits share the first switch circuit Q1 in the control circuit. The laser emission circuit includes a first switch circuit Q1 and a second switch circuit Q2, the second laser emission circuit includes the first switch circuit Q1 and a second switch circuit Q4, and the third laser emission circuit includes the first switch circuit Q1 and the second switch circuit Q6. Based on the connection shown in FIG. 6, the first switch circuit Q1 can turn on and off the power supply and the energy storage circuit L1 and C1 based on the drive signal, and the second switch circuits Q2, Q4, and Q6 can turn on and off the connection between C1 and D1, D2, and D3 based on the drive signal.

In some embodiments, in at least one laser emission circuit, the energy storage circuit may include an inductor and a capacitor, and the first switch circuit and the second switch circuit may be the same switch circuit. The switch circuit may be used to turn on and off the connection between the power supply and the energy storage circuit of the laser emission circuit, and turn on and off the connection between the energy storage circuit and the laser emitter based on the drive signal. In the embodiment shown in FIG. 18, the first laser emission circuit shares the first switch circuit and the second switch circuit, which is embodied as a switch Q1. The second laser emission circuit shares the first switch circuit and the second switch circuit, which is embodied as a switch Q2. The third laser emission circuit shares the first switch circuit and the second switch circuit, which is embodied as a switch Q3.

In some embodiments, the first switch circuit and the second switch circuit may be the same switch circuit, and the same switch circuit may implement the functions of the first switch circuit and the second switch circuit respectively in time sequence. In the embodiment shown in FIG. 18, the first laser emission circuit shares the first switch circuit and the second switch circuit, which is embodied as a switch Q1. The second laser emission circuit shares the first switch circuit and the second switch circuit, which is embodied as a switch Q2. The third laser emission circuit shares the first switch circuit and the second switch circuit, which is embodied as a switch Q3. Based on the timing sequence diagram shown in FIG. 21, the switch Q1 can realize the functions of the first switch circuit and the second switch circuit in different periods of time. During a part of the time, the power supply and the energy storage circuit may be turned on, and in a part of the time, the capacitor and the laser emitter may be turned on.

In some embodiments, in the at least two laser emission circuits, the pulse widths for controlling the first switch circuit in the at least two laser emission circuits may be different and/or the pulse widths for controlling the second switch circuit in the at least two laser emission circuits may be different. The drawings of the present disclosure do not clearly indicate whether the pulse widths of the first switch circuits in different laser emission circuits are the same, but, optionally, the pulse widths of the first switch circuits in the different laser emission circuits described above can be selected separately, for example, the pulse widths may be different or partially the same.

In some embodiments, the at least two laser emission circuits may share at least part of the energy storage circuit. For example, in the embodiment shown in FIG. 6, the three laser emission circuits share the resistor R1 and the capacitor C1. In the embodiment shown in FIG. 19, the three laser emission circuits share the inductor L1 and the capacitor C1. In other embodiments, only the capacitor may be shared without sharing the inductor.

In some embodiments, the energy storage circuit may store energy in different periods of time, and supply power to the laser emitters in different laser emission circuits in different periods of time. For example, in the embodiment shown in FIG. 6, based on the timing sequence diagram, the inductor and the capacitor can store energy in different periods of time, and respectively supply power to the laser emitters in the first to the third laser emission circuits.

In some embodiments, the energy storage circuit may include a resistor and a capacitor. For example, in the embodiment shown in FIG. 6, the energy storage circuit of the three laser emission circuits includes a resistor R1 and a capacitor C1

In some embodiments, the two or more laser emission circuits share the resistor and/or the capacitor. For example, in the embodiment shown in FIG. 6, the three laser emission circuits share the resistor R1 and the capacitor C1. In other embodiments, it is also possible to share only the capacitor without sharing the resistor, or only share the resistor without sharing the capacitor.

In some embodiments, in a laser emission circuit, in the first period of time, the first loop may be turned on. The first loop may include the power supply, the resistor, and the capacitor connected in series, and the power supply may charge the capacitor through the resistor. In the second period of time, the second loop may be turned on. The second loop may include the capacitor and the laser emitter connected in series. For example, in the embodiment shown in FIG. 6 and in conjunction with its control sequence shown in FIG. 13, the first loop includes a power supply, a resistor R1, and a capacitor C1. In addition, in the first period of time, the power supply can charge the capacitor C1 through the resistor R1. The second loop includes the capacitor and D1-D3. In the second period of time, the capacitor may be respectively connected to the laser diodes D1, D2, and D3.

In some embodiments, the energy storage circuit may include an inductor and a capacitor. For example, in the embodiment shown in FIG. 19, the energy storage circuit includes an inductor L1 and a capacitor C1.

In some embodiments, the two or more laser emission circuits may share the inductor and/or the capacitor. For example, in the embodiment shown in FIG. 19, the three laser emission circuits share the inductor L1 and the capacitor C1.

In some embodiments, the first period of time may include a third period of time and a fourth period of time. In a laser emission circuit, in the third period of time, the first loop may be turned on. The first loop may include the power supply and the inductor connected in series, and the power supply may be used to charge the inductor. In the fourth period of time, the second loop may be turned on. The second loop may include the inductor and the capacitor connected in series, and the inductor may be used to charge the capacitor. In the second period of time, the third loop may be turned on, and the capacitor and the laser emitter may be turned on. In some embodiments, the third period of time and the second period of time may at least partially overlap. For example, in the embodiment shown in FIG. 8 and FIG. 9, when the first switch circuit Q1 is turned on, the power supply is connected in series with the inductor L1, and the power supply charges the inductor L1. This time is the third period of time. When the first switch circuit Q1 is turned off, the inductor L1 and the capacitor C1 are connected in series, and the inductor L1 charges the capacitor C1. This time is the fourth period of time. The second switch circuit, for example, when Q2 is turned on, the capacitor C1 and D2 are connected, and the capacitor C1 discharges to D2. This is the second period of time. In other embodiments, in the second period of time, the discharge process is very short, and the current of the indicator L1 cannot change rapidly. After the discharge is completed, the power supply can still charge the inductor L1. Therefore, the third period of time and the second period of time overlap, and the third period of time can also completely overlap the second period of time.

In some embodiments, the control circuit may include a switch circuit for turning on and off based on a drive signal. The first loop may include the power supply, the inductor, the first diode, the laser emitter, and the switch circuit connected in series. The second loop may include the inductor, the first diode, and the capacitor connected in series. The third loop may include the capacitor, the laser emitter, and the switch circuit connected in series. In some embodiments, the control circuit may include a switch circuit for turning on and off based on a drive signal. The first loop may include the power supply, the inductor, the first diode, and the switch circuit connected in series. The second loop may include the inductor, the first diode, the second diode, and the capacitor connected in series. The third loop may include the capacitor, the laser emitter, and the switch circuit connected in series.

For example, in the embodiment shown in FIG. 19, in the first laser emission circuit, the first loop includes a power supply, an inductor L1, a diode D1, a laser diode D3, and a switch circuit Q1, which are connected in series. The second loop includes the inductor L1, diodes D1 and D2, and a capacitor C1, which are connected in series. The third loop includes the capacitor C1, the laser diode D3, and the switch circuit Q1.

In some embodiments, the control circuit may include a first switch circuit and a second switch circuit, and the first switch circuit and the second switch circuit may be connected to each laser emitter in the at least two laser emission circuits through the resistor. One end of the capacitor may be connected to the resistor and the common end of each laser emitter in the at least two laser emission circuits, and the other end may be connected to each second switch circuit in the at least two laser emission circuits. In some embodiments, each laser emission circuit may include a second switch circuit, and the second switch circuit may include a field effect transistor. A first end of the second switch circuit may be used for receiving a drive signal, a second end may be connected to the capacitor, and a third end may be connected to the resistor. In some embodiments, the laser emitter in each laser emission circuit may be positioned between the second end of the second switch circuit and the capacitor, or positioned between the third end and the resistor.

For example, in the embodiment shown in FIG. 6, a first switch circuit Q1 and a plurality of second switch circuits Q2, Q4, and Q6 are included. The first switch circuit Q1 is connected to each laser emitter D1, D2, and D3 through a resistor R1. One end of the capacitor C1 is connected to the common end of the resistor R1 and each laser emitter D1, D2, and D3, and the other end is connected to the plurality of second switch circuits Q2, Q4, and Q6. In some embodiments, the plurality of second switch circuits Q2, Q4, and Q6 may be field effect transistors, where one end may be connected to the START signal, the second end may be connected to the capacitor C1, and the third end may be connected to the resistor R1. Each laser emitters D1, D2, and D3 in each laser emission circuit may be positioned between the second end of the second switch circuits Q2, Q4, and Q6, and the capacitor C1, or positioned between the third end and the resistor R1.

In some embodiments, a first diode may be included. The control circuit may include a first switch circuit and a second switch circuit. One end of the inductor may be connected to the power supply, and the other end may be connected to the third end of the first switch circuit. One end of the capacitor may be connected to the common end of the first diode and each laser emitter in the at least two laser emission circuits, and the other end may be connected to each second switch circuit in the at least two laser emission circuits. The second switch circuit may include a field effect transistor. For example, in the embodiment shown in FIG. 8, a diode D1 is included. The control circuit includes a first switch circuit Q1 and a plurality of second switch circuits Q2, Q4, and Q6. One end of the inductor L1 is connected to the power supply, and the other end is connected to the third end of the first switch circuit Q1. One end of the capacitor C1 is connected to the common end of the diode D1 and the laser emitters D2, D4, and D6 of the three laser emission circuits, and the other end is connected to each of the second switch circuits Q2, Q4, and Q6 in the three laser emission circuits. The second switch circuits Q2, Q4, and Q6 include field effect transistors.

In some embodiments, the first end of the first switch circuit may be used to receive a drive signal, and the third end may be grounded. For example, in the embodiment shown in FIG. 8, the first end of the first switch circuit Q1 receives the CRT control signal, and the third end is grounded.

In some embodiments, each laser emission circuit may include a second switch circuit. The first end of the second switch circuit may be used for receiving the drive signal, the second end may be connected to the capacitor, and the third end may be connected to the inductor. In some embodiments, the laser emitter in each laser emission circuit may be positioned between the second end of the second switch circuit and the capacitor, or between the third end and the inductor.

For example, in the embodiment shown in FIG. 8, each laser emission circuit includes a plurality of second switch circuits Q2, Q4, and Q6. The first ends of the second switch circuits Q2, Q4, and Q6 are used to receive the drive signal START, the second ends are connected to the capacitor C1, and the third ends are connected to the inductor L1. The laser emitters D2, D4, and D6 are positioned between the second ends of the second switch circuits Q2, Q4, and Q6 and the capacitor, or between the third end and the inductor L1.

In some embodiments, one end of the first diode may be connected to the inductor, and the other end may be connected to each laser emitter in the at least two laser emission circuits. For example, in the embodiment shown in FIG. 8, one end of the diode D1 is connected to the inductor L1, and the other end is connected to the laser emitters D2, D4, and D6.

In some embodiments, a first diode may be included. The control circuit may include a third switch circuit. One end of the inductor may be connected to the power supply, and the other end may be connected to the capacitor and the common end of each laser emitter in the at least two laser emission circuits through the first diode. One end of the capacitor may be connected to the common end of the first diode and each laser emitter in the at least two laser emission circuits, and the other end may be connected to each second switch circuit in the at least two laser emission circuits. For example, in the embodiment shown in FIG. 15, a diode D1 is included. The control circuit includes a plurality of switch circuits Q2, Q4, and Q6. One end of the inductor L1 is connected to the power supply, and the other end is connected to the common end of the capacitor C1 and the laser emitters D2, D4, and D6 through the diode D1. One end of the capacitor C1 is connected to the common end of the diode D1 and the laser emitter D2, D4, and D6, and the other end is connected to the plurality of switch circuits Q2, Q4, and Q6.

In some embodiments, the first end of the third switch circuit may be used to receive the drive signal, the second end may be connected to the capacitor, and the third end may be connected to the inductor. For example, in the embodiment shown in FIG. 15, the first ends of the switch circuits Q2, Q4, and Q6 are used to receive the drive signal START, the second ends are used to connect to the capacitor C1, and the third ends are used to connect to the inductor L1.

In some embodiments, the laser emitter in each laser emission circuit may be positioned between the second end of the third switch circuit and the capacitor, or between the third end and the inductor. For example, in the embodiment shown in FIG. 15, the laser emitters D2, D4, and D6 in each laser emission circuit are positioned between the second end of the third switch circuit and the capacitor C1, or between the third end and the inductor L1

In some embodiments, a first diode is included. The control circuit may include a third switch circuit. One end of the inductor may be connected to the power supply, and the other end may be connected to the common end of each first diode in the at least two laser emission circuits. One end of the capacitor may be grounded, and the other end may be connected to the common end of each second diode in the at least two laser emission circuits. For example, in the embodiment shown in FIG. 19, diodes D1, D4, and D7 are included. The control circuit includes a plurality of third switch circuits Q1, Q2, and Q3. One end of the inductor L1 is connected to the power supply, and the other end is connected to the common end of each of the first diodes D1, D4 and D7 in the three laser emission circuits. One end of the capacitor C1 is grounded, and the other end is connected to the common ends of the second diodes D2, D5, and D8 in the three laser emission circuits.

In some embodiments, each of the at least two laser emission circuits may include a first diode, a third switch circuit, a second diode, and a laser emitter. For example, in the embodiment shown in FIG. 19, the three laser emission circuits include the first diodes D1, D4, and D7, the third switch circuits Q1, Q2, and Q3, the second diodes D2, D5, and D8, and the laser emitters D3, D6, and D9.

In some embodiments, in each laser emission circuit, the first end of the third switch circuit may be used to receive the drive signal, the second end may be grounded, and the third end may be connected to the common end of the first diode and the second diode. For example, in the embodiment shown in FIG. 19, the three laser emission circuits the first ends of the third switch circuits Q1, Q2, and Q3 receive the START drive signal, the second ends are grounded, and the third ends are respective connected to the common ends of D1 and D2, the common end of D4 and D5, and the common ends of D7 and D8.

In some embodiments, the second diode in each laser emission circuit may be connected in anti-parallel to the two ends of the laser emitter. For example, in the embodiment shown in FIG. 18 and FIG. 19, the diode D2 is reversely connected to the two ends of the laser emitter D3, the diode D5 is reversely connected to the two ends of the laser emitter D6, and the diode D8 is reversely connected to the two ends of the laser emitter D9.

In some embodiments, the at least two laser emission circuits may respectively emit light pulse signals in different directions. For example, the light pulse signals emitted by the three laser emission circuits may face different directions, which is not limited in the present disclosure.

In some embodiments, the emission chips in the laser emitters in the at least two laser emission circuits may be packaged in the same enclosed space. For example, the emission chips in the three laser emission circuits may be packaged in one device.

In some embodiments, the light emitting device may further include a reset circuit. The reset circuit may include a switch circuit connected to the energy storage circuit. In some embodiments, the reset circuit may reset the voltage in at least part of the circuit on the energy storage circuit before and/or after the laser emitter emits the light pulse.

For example, in the embodiment shown in FIG. 26, a reset circuit Q4 is included. Q4 is a switch circuit, which is connected to the energy storage circuit L1 and C1. With reference to the timing sequence diagram of FIG. 27, after the first laser emission circuit emits light, the reset circuit Q4 discharges and resets the voltage on the capacitor C1.

In some embodiments, in at least some circuits, the parameters of the energy storage circuits of different circuits may be different. For example, the parameters of the energy storage circuits in the three circuits may be different, such that the laser emitters in the three laser emission circuits can be controlled respectively.

In some embodiments, in at least some circuits, the conduction time of the energy storage circuit and the power supply may be different; and/or the conduction time of the energy storage circuit and the laser emitter may be different. For example, the conduction time of the energy storage circuit and the power supply in the three circuits may be different; and/or the conduction time of the energy storage circuit and the laser emitter may be different, such that the laser emitters in the three laser emission circuits may be respectively controlled.

The light emitting device provided by each embodiment of the present disclosure may also be applied to a distance measuring device, and the distance measuring device may be an electronic device, such as a lidar and a laser distance measuring device. In one embodiment, the distance measuring device may be used to sense external environmental information, such as distance information, orientation information, reflection intensity information, speed information, etc. of targets in the environment. In one implementation, the distance measuring device may detect the distance between the distance measuring device and an object to be detected by measuring a time of light propagation between the distance measuring device and the object to be detected, that is, the time-of-flight (TOF). Alternatively, the distance measuring device may also use other technologies to detect the distance from the object to be detected to the distance measuring device, such as a distance measuring method based on phase shift measurement or a distance measuring method based on frequency shift measurement, which is not limited here.

For the ease of understanding, the workflow of distance measuring will be described below with reference to a distance measuring device 100 shown in FIG. 22 as an example.

As shown in FIG. 22, the distance measuring device 100 includes a transmitting circuit 110, a receiving circuit 120, a sampling circuit 130, and an arithmetic circuit 140.

The transmitting circuit 110 may emit a light pulse sequence (e.g., a laser pulse sequence). The receiving circuit 120 can receive the light pulse sequence reflected by the object to be detected, and perform photoelectric conversion on the light pulse sequence to obtain an electrical signal, and then the electrical signal can be processed and output to the sampling circuit 130. The sampling circuit 130 can sample the electrical signal to obtain a sampling result. The arithmetic circuit 140 may determine the distance between the distance measuring device 100 and the object to be detected based on the sampling result of the sampling circuit 130.

In some embodiments, the distance measuring device 100 may further include a control circuit 150. The control circuit 150 can control other circuit, for example, control the working time of each circuit and/or set parameters for each circuit, etc.

It should be understood that although the distance measuring device shown in FIG. 22 includes a transmitting circuit, a receiving circuit, a sampling circuit, and an arithmetic circuit to emit a light beam for detection, however, the embodiments of the present disclosure are not limited thereto. The number of any one of the transmitting circuit, the receiving circuit, the sampling circuit, and the arithmetic circuit may also be at least two, which can be used to emit at least two light beams in the same direction or different directions. In some embodiments, the at least two light beams may be emitted at the same time or at different times. In one example, the light emitting chips in the at least two emitting circuits may be packaged in the same module. For example, each transmitting circuit may include a laser transmitting chip, and the dies in the laser transmitting chips in the at least two transmitting circuits may be packaged together and housed in the same packaging space.

In some implementations, in addition to the circuit shown in FIG. 1, the light detection device 100 may further include a scanning module 160, which can be used to change the propagation direction of at least one laser pulse sequence emitted by the transmitting circuit and emit it.

In some embodiments, a module including the transmitting circuit 110, the receiving circuit 120, the sampling circuit 130, and the arithmetic circuit 140 may be referred to as a distance measuring module. The distance measuring module 150 may be independent of other modules, such as the scanning module 160.

A coaxial light path may be used in the distance measuring device, that is, the light beam emitted by the distance measuring device and the reflected light beam can share at least a part of the light path in the distance measuring device. For example, after at least one laser pulse sequence emitted by the transmitting circuit changes its propagation direction through the scanning module and exits, the laser pulse sequence reflected by the object to be detected may pass through the scanning module and enter the receiving circuit. Alternatively, the distance measuring device may also adopt an off-axis light path, that is, the light beam emitted by the distance measuring device and the reflected light beam may be respectively transmitted along different light paths in the distance measuring device. FIG. 23 is a schematic diagram of a light detection device using a coaxial light path according to an embodiment of the present disclosure.

A distance measuring device 200 includes a distance measuring module 210. The distance measuring module 210 includes a transmitter 203 (including the transmitting circuit described above), a collimating element 204, a detector 205 (which may include the receiving circuit, sampling circuit, and arithmetic circuit described above), and a light path changing element 206. The distance measuring module 210 may be used to transmit the light beam, received the returned light, and convert the returned light into an electrical signal. In some embodiments, the transmitter 203 may be used to emit a light pulse sequence. In one embodiment, the transmitter 203 may emit laser pulses. In some embodiments, the laser beam emitted by the transmitter 203 may be a narrow-bandwidth light beam with a wavelength outside the visible light range. The collimating element 204 may be disposed on an exit light path of the transmitter and used to collimate the light beam emitted from the transmitter 203 and collimate the light beam emitted from the transmitter 203 into parallel light and output to the scanning module. The collimating element may also be used to condense at least a part of the returned light reflected by the object to be detected. The collimating element 204 may be a collimating lens or other elements capable of collimating light beams.

In the embodiment shown in FIG. 23, by using the light path changing element 206 to combine the transmitting light path and the receiving light path in the distance measuring device before the collimating element 104, the transmitting light path and the receiving light path can share the same collimating element, making the light path more compact. In some other implementations, the transmitter 103 and the detector 105 may also use their respective collimating elements, and the light path changing element 206 may be disposed on the light path behind the collimating element.

In the embodiment shown in FIG. 23, since the beam aperture of the light beam emitted by the transmitter 103 is relatively small, and the beam aperture of the returned light received by the distance measuring device is relatively large, the light path changing element may use a small-area mirror to combine the emitting light path and the receiving light path. In some other implementations, the light path changing element may also adopt a reflector with a through hole, where the through hole may be used to transmit the emitted light of the transmitter 203, and the reflector may be used to reflect the returned light to the detector 205. In this way, it is possible to reduce the blocking of the returned light by the support of the small reflector when the small reflector is used.

In the embodiment shown in FIG. 23, the light path changing element may deviate from the optical axis of the collimating element 204. In some other implementations, the light path changing element may also be positioned on the optical axis of the collimating element 204.

The distance measuring device 200 may further include a scanning module 202. The scanning module 202 may be disposed on the exit light path of the distance measuring module 210. The scanning module 102 may be used to change the transmission direction of a collimated light beam 219 emitted by the collimating element 204, and project the returned light to the collimating element 204. The returned light may be collected on the detector 105 via the collimating element 104.

In one embodiment, the scanning module 202 may include at least one optical element for changing the propagation path of the light beam, where the optical element may change the propagation path of the light beam by reflecting, refracting, or diffracting the light beam. For example, the scanning module 202 may include a lens, a mirror, a prism, a galvanometer, a grating, a liquid crystal, an optical phased array, or any combination of the foregoing optical elements. In one example, at least part of the optical element may be movable. For example, the at least part of the optical element may be driven by a driving module, and the movable optical element can reflect, refract, or diffract the light beam to different directions at different times. In some embodiments, a plurality of optical elements of the scanning module 202 may rotate around a common axis 209, and each rotating or vibrating optical element may be used to continuously change the propagation direction of the incident light beam. In one embodiment, the plurality of optical elements of the scanning module 202 may rotate at different rotation speeds or vibrate at different speeds. In another embodiment, the plurality of optical elements of the scanning module 202 may rotate at substantially the same rotation speed. In some embodiments, the plurality of optical elements of the scanning module 202 may also be rotated around different axes. In some embodiments, the plurality of optical elements of the scanning module 202 may also be rotated in the same direction or in different directions, or vibrate in the same direction or different directions, which is not limited herein.

In one embodiment, the scanning module 202 may include a first optical element 214 and a driver 216 connected to the first optical element 214. The driver 216 may be used to drive the first optical element 214 to rotate around the rotation axis 209, such that the first optical element 214 can change the direction of the collimated light beam 219. The first optical element 214 may project the collimated light beam 219 to different directions. In one embodiment, an angle between the direction of the collimated light beam 219 changed by the first optical element and the rotation axis 109 may change with the rotation of the first optical element 214. In one embodiment, the first optical element 214 may include a pair of opposite non-parallel surfaces, and the collimated light beam 219 may pass through the pair of surfaces. In one embodiment, the first optical element 214 may include a prism whose thickness may vary in at least one radial direction. In one embodiment, the first optical element 214 may include a wedge-angle prism to collimate the beam 119 for refracting.

In one embodiment, the scanning module 202 may further include a second optical element 215. The second optical element 215 may rotate around the rotation axis 209, and the rotation speed of the second optical element 215 may be different from the rotation speed of the first optical element 214. The second optical element 215 may be used to change the direction of the light beam projected by the first optical element 214. In one embodiment, the second optical element 115 may be connected to another driver 217, and the driver 117 may drive the second optical element 215 to rotate. The first optical element 214 and the second optical element 215 may be driven by the same or different drivers, such that the first optical element 214 and the second optical element 215 may have different rotation speeds and/or steering directions, such that the collimated light beam 219 may be projected to different directions in the external space to scan a larger spatial range. In one embodiment, a controller 218 may control the driver 216 and driver 217 to drive the first optical element 214 and the second optical element 215, respectively. The rotation speeds of the first optical element 214 and the second optical element 215 may be determined based on the area and pattern expected to be scanned in actual applications. The drivers 216 and 217 may include motors or other driving devices.

In some embodiments, the second optical element 115 may include a pair of opposite non-parallel surfaces, and a light beam may pass through the pair of surface. In one embodiment, the second optical element 115 may include a prism whose thickness may vary in at least one radial direction. In one embodiment, the second optical element 115 may include a wedge-prism.

In one embodiment, the scanning module 102 may further include a third optical element (not shown in the drawings) and a driver for driving the third optical element to move. In some embodiments, the third optical element may include a pair of opposite non-parallel surfaces, and a light beam may pass through the pair of surface. In one embodiment, the second optical element may include a prism whose thickness may vary in at least one radial direction. In one embodiment, the second optical element may include a wedge-prism. At least two of the first, second, and third optical elements may rotate at different rotation speeds and/or rotation directions.

The rotation of each optical element in the scanning module 202 may project light to different directions, such as directions of light 211 and 213, such that the space around the distance measuring device 200 can be scanned. When the light 211 projected by the scanning module 202 hits an object to be detected 201, a part of the light may be reflected by the object to be detected 201 to the distance measuring device 200 in a direction opposite to the projected light 211. The returned light 212 reflected by the object to be detected 201 may incident on the collimating element 204 after passing through the scanning module 202.

The detector 205 and the transmitter 203 may be placed on the same side of the collimating element 204, and the detector 205 may be used to convert at least part of the returned light passing through the collimating element 204 into electrical signals.

In one embodiment, each optical element may be coated with an anti-reflection coating. In some embodiments, the thickness of the anti-reflection coating may be equal to or close to the wavelength of the light beam emitted by the transmitter 103, which can increase the intensity of the transmitted light beam.

In one embodiment, a filtering layer may be plated on the surface of an element positioned on the light beam propagation path in the distance measuring device, or a filter may be disposed on the light beam propagation path for transmitting at least the wavelength band of the light beam emitted by the transmitter, and reflect other wavelength bands to reduce the noise caused by ambient light to the receiver.

In some embodiments, the transmitter 203 may include a laser diode, and nanosecond laser pulses may be emitted through the laser diode. Further, the laser pulse receiving time may be determined, for example, by detecting the rising edge time and/or falling edge time of the electrical signal pulse to determine the laser pulse receiving time. In this way, the distance measuring device 200 may calculate the TOF using the pulse receiving time information and the laser pulse sending time information, thereby determining the distance from the object to be detected 201 to the distance measuring device 200.

The distance and orientation detected by the distance measuring device 200 may be used for remote sensing, obstacle avoidance, surveying and mapping, navigation, and the like. In one embodiment, the distance measuring device of the embodiments of the present disclosure can be applied to a mobile platform, and the distance measuring device can be mounted on the platform body of the mobile platform. The mobile platform including the distance measuring device can measure the external environment, such as measuring the distance between the mobile platform and obstacles for obstacle avoidance and other purposes, and for two-dimensional or three-dimensional mapping of the external environment. In some embodiments, the mobile platform may include at least one of an unmanned aerial vehicle, a car, a remote control car, a robot, and a camera. When the distance measuring device is applied to an unmanned aerial vehicle, the platform body may be the body of the unmanned aerial vehicle. When the distance measuring device is applied to a car, the platform body may be the body of the car. The car may be a self-driving vehicle or a semi-self-driving vehicle, which is not limited here. When the distance measuring device is applied to a remote control car, the platform body may be the body of the remote control car. When the distance measuring device is applied to a robot, the platform body may be the robot. When the distance measuring device is applied to a camera, the platform body may be the camera itself.

The light emitting device, distance measuring device, and mobile platform provided in the previous embodiments of the present disclosure provide a product that can realize the individual adjustment of laser emission power and is suitable for multi-circuit laser emission. The following advantages can be achieved by individually adjusting the multi-circuit laser emission. First the calibration of the light energy of different light emitters can be achieved to compensate for the difference of each circuit. Second, the multi-circuit laser emitters can meet the human eye safety regulations. Third, the circuit is simplified and the cost is reduced. The embodiments of the present disclosure can achieve at least the first advantage described above. In some embodiments, the second advantage can be achieved at the same time, and in some other embodiments, all of the above advantages can be achieved.

The technical terms used in the embodiments of the present disclosure are merely used to describe some embodiments and are not intended to limit the present disclosure. As used herein, the singular forms "a", "an", and "the" are intended to include the plural forms as well, unless the context clearly indicates other cases. Further, the use of "including" and/or "comprising" when used in the specification means that the features, integers, steps, operations, elements and/or components are present but do not preclude the presence or addition of one or more other features, integers, steps, operations, elements, and/or components.

The corresponding structures, materials, acts, and equivalents of all means or steps, and function elements, if any, in the appended claims are intended to include any structure, material, or act for performing the function in combination with other explicitly claimed elements. The description of the present disclosure has been presented for purposes of illustration and description, but is not intended to be exhaustive or limited to the disclosure in the form disclosed. Many modifications and variations will be apparent to those skilled in the art without departing from the scope and spirit of the disclosure. The embodiments described in the present disclosure can better understand the principle and practical application of the present disclosure and make those skilled in the art understand the present disclosure.

The flowchart described in the present disclosure is merely an example and various modifications may be made to this illustration or the steps in the present disclosure without departing from the spirit of the present disclosure. For example, these steps can be executed in different orders, or some steps can be added, deleted, or modified. Those of ordinary skill in the art can understand that all or part of the procedures for implementing the foregoing embodiments and equivalent variations made according to the claims of the present disclosure still fall in the scope of the present disclosure.

**Claims**

1. A light emitting device comprising:

   at least two laser emission circuits, each of the laser emission circuits including a power supply, a laser emitter, an energy storage circuit, and a control circuit, wherein
   in each of the laser emission circuits, the control circuit is configured to turn on the energy storage circuit and the power supply in the laser emission circuit in a first period of time for the power supply to store energy in the energy storage circuit;
   the control circuit is further configured to turn on the laser emitter and the energy storage circuit in the laser emission circuit in a second period of time for the energy storage circuit to supply power to the laser emitter for the laser emitter to emit a light pulse signal; and
two or more laser emission circuits share the power supply.

2. The light emitting device of claim 1, wherein:
in the at least two laser emission circuits, the laser emitter in each laser emission circuit is configured to emit a light pulse sequence, and the at least two laser emission circuits alternately emit the light pulse sequence.

3. The light emitting device of claim 2, wherein:
between two adjacent emission of the light pulse signals of one laser emission circuit of the at least two laser emission circuits, a remaining laser emission circuit of the at least two laser emission circuits respectively emit one light pulse signal in sequence.

4. The light emitting device of any one of claims 1 to 3, wherein:
the two or more laser emission circuits share at least part of the control circuit.

5. The light emitting device of claim 4, wherein:
the control circuit is configured to control the laser emission circuits in different periods of time and output light signals of the laser emitters in the laser emission circuits in different periods of time.

6. The light emitting device of claim 4, wherein:

the control circuit includes a first switch circuit and a second switch circuit; and
in each of the laser emission circuits, the first switch circuit is configured to turn on and off a connection between the power supply and the energy storage circuit of the laser emission circuit based on a drive signal, and the second switch circuit is configured to turn on and off a connection between the energy storage circuit and the laser emitter based on the drive signal.

7. The light emitting device of claim 6, wherein:
two laser emission circuits share the first switch circuit and/or the second switch circuit.

8. The light emitting device of claim 6 to 7, wherein:

the first switch circuit is configured to control a conduction and disconnection of the energy storage circuit in different laser emission circuits and the power supply in different periods of time based on the drive signal, and/or
the second switch circuit is configured to control a conduction and disconnection of the energy storage circuit in different laser emission circuits and the laser emitter in different periods of time based on the drive signal.

9. The light emitting device of claim 6, wherein
in at least one laser emission circuit, the energy storage circuit includes an inductor and a capacitor, and the first switch circuit and the second switch circuit are the same switch circuit, the switch circuit being configured to turn on and off the connection between the power supply and the energy storage circuit of the laser emission circuit, and turn on and off the connection between the energy storage circuit and the laser emitter based on the drive signal.

10. The light emitting device of claim 8, wherein:
the first switch circuit and the second switch circuit are the same switch circuit, and the same switch circuit is configured to implement the functions of the first switch circuit and the second switch circuit respectively in time sequence.

11. The light emitting device of any one of claims 1-3, 5-7, 9, and 10, wherein:
in the at least two laser emission circuits, pulse widths for controlling the first switch circuit in the at least two laser emission circuits are different and/or the pulse widths for controlling the second switch circuit in the at least two laser emission circuits are different.

12. The light emitting device of any one of claims 1-3, wherein:
at least two laser emission circuits share at least part of the energy storage circuit.

13. The light emitting device of claim 12, wherein:
the energy storage circuit stores energy in different periods of time and supplies power to the laser emitters in different laser emission circuits in different periods of time.

14. The light emitting device of claim 12, wherein:
the energy storage circuit includes a resistor and a capacitor.

15. The light emitting device of claim 14, wherein:
the two or more laser emission circuits share the resistor and/or the capacitor.

16. The light emitting device of claim 14, wherein in one laser emission circuit:

in the first period of time, a first loop is turned on, the first loop including the power supply, the resistor, and the capacitor connected in series, the power supply charging the capacitor through the resistor, and
in the second period of time, a second loop is turned on, the second loop including the capacitor and the laser emitter connected in series.

**17.** The light emitting device of claim 10, wherein:
the energy storage circuit includes an inductor and a capacitor.

**18.** The light emitting device of claim 17, wherein:
the two or more laser emission circuits share the inductor and/or the capacitor.

**19.** The light emitting device of claim 17, wherein:

the first period of time includes a third period of time and a fourth period of time, and
in one laser emission circuit:

in the third period of time, the first loop is turned, the first loop including the power supply and the inductor connected in series, and the power supply is used to charge the inductor;
in the fourth period of time, the second loop is turned on, the second loop including the inductor and the capacitor connected in series, and the inductor is used to charge the capacitor;
in the second period of time, a third loop is turned on and the capacitor and the laser emitter are turned on.

**20.** The light emitting device of claim 19, wherein:
the third period of time and the second period of time at least partially overlap.

**21.** The light emitting device of claim 19, wherein:

the control circuit includes a switch circuit for turning on and off based on the drive signal;
the first loop includes the power supply, inductor, a first diode, the laser emitter, and the switch circuit connected in series;
the second loop includes the inductor, the first diode, and the capacitor connected in series; and
the third loop includes the capacitor, the laser emitter, and the switch circuit.

**22.** The light emitting device of claim 19, wherein:

the control circuit includes a switch circuit for turning on and off based on the drive signal;
the first loop includes the power supply, the inductor, the first diode, and the switch circuit connected in series;
the second loop includes the inductor, the first diode, the second diode, and the capacitor connected in series; and
the third loop includes the capacitor, the laser emitter, and the switch circuit connected in series.

**23.** The light emitting device of claim 14, wherein:
the control circuit includes a first switch circuit and a second switch circuit, the first switch circuit being connected to each laser emitter in the at least two laser emission circuits through the resistor, one end of the capacitor being connected to the resistor and a common end of each laser emitter in the at least two laser emission circuits, and the other end being connected to each second switch circuit in the at least two laser emission circuits.

**24.** The light emitting device of claim 23, wherein:
each laser emission circuit includes one second switch circuit, the second switch circuit including a field effect tube, a first end of the second switch circuit being configured to receive the drive signal, a second end being connected to the capacitor, and a third end being connected to the resistor.

**25.** The light emitting device of claim 24, wherein:
the laser emitter in each laser emission circuit is positioned between the second end of the second switch circuit and the capacitor, or between the third end and the resistor.

**26.** The light emitting device of claim 17 further includes:

a first diode, wherein
the control circuit includes a first switch circuit and a second switch circuit, one end of the inductor being connected to the power supply, and the other end being connected to a third end of the first switch circuit, one end of the capacitor being connected to a common end of the first diode and each laser emitter in the at least two laser emission circuits, and the other end being connected to each second switch circuit in the at least two laser emission circuits, the second switch circuit including a field effect tube.

**27.** The light emitting device of claim 26, wherein:
a first end of the first switch circuit is configured to receive the drive signal, and the third end is grounded.

**28.** The light emitting device of claim 26 or 27, wherein:
each laser emission circuit includes one second switch circuit, a first end of the second switch circuit being configured to receive the drive signal, a second end being connected to the capacitor, and a third end being connected to the inductor.

**29.** The light emitting device of claim 28, wherein:
the laser emitter in each laser emission circuit is positioned between the second end of the second switch circuit and the capacitor, or between the third end and the inductor.

**30.** The light emitting device of claim 28, wherein:
one end of the first diode is connected to the inductor, and the other end is connected to each laser emitter in the at least two laser emission circuits.

**31.** The light emitting device of claim 17 further includes:

a first diode, wherein
the control circuit includes a third switch circuit, one end of the inductor being connected to the power supply, the other end being connected to the capacitor and a common end of each laser emitter in the at least two laser emission circuits through the first diode, one end of the capacitor being connected to a common end of the first diode and each laser emitter in the at least two laser emission circuits, the other end being connected to each third switch circuit in the at least two laser emission circuits.

**32.** The light emitting device of claim 31, wherein:
a first end of the third switch circuit is configured to receive the drive signal, a second end is configured to connect the capacitor, and a third end is configured to connect the inductor.

**33.** The light emitting device of claim 32, wherein:
the laser emitter in each laser emission circuit is positioned between the second end of the third switch circuit and the capacitor, or between the third end and the inductor.

**34.** The light emitting device of claim 17 further include:

a first diode, wherein
the control circuit includes a third switch circuit, one end of the inductor being connected to the power supply, the other end being connected to a common end of each first diode in the at least two laser emission circuits, one end of the capacitor being grounded, the other end being connected to a common end of each second diode in the at least two laser emission circuits.

**35.** The light emitting device of claim 34, wherein:
each of the at least two laser emission circuits includes the first diode, the third switch circuit, the second diode, and the laser emitter.

**36.** The light emitting device of claim 35, wherein:
in each laser emission circuit, a first end of the third switch circuit is configured to receive the drive signal, a second end is grounded, and a third end is connected to the common end of the first diode and the second diode.

**37.** The light emitting device of any one of claims 34-36, wherein:

the second diode in each laser emission circuit is connected in anti-parallel to both ends of the laser emitter.

**38.** The light emitting device of any one of claims 1-37, wherein:
the at least two laser emission circuits emit light pulse signals in different directions.

**39.** The light emitting device of any one of claims 1-37, wherein:
emission chips in the laser emitters in the at least two laser emission circuits are packaged in a same enclosed space.

**40.** The light emitting device of any one of claims 1-37 further comprising:
a reset circuit, the reset circuit being configured to reset the energy storage circuit based on a control signal.

**41.** The light emitting device of claim 40, wherein:
the reset circuit includes a capacitor, and the reset circuit includes a switch circuit configured to release energy stored in the capacitor when it is turned on.

**42.** The light emitting device of claim 40 or 41, wherein:
the reset circuit is configured to reset a voltage on at least part of the circuit of the energy storage circuit before and/or after the laser emitter emits the light pulse based on the control signal.

**43.** The light emitting device of any one of claims 1-42, wherein:
in at least part of the circuits, parameters of the energy storage circuit of different circuits are different.

**44.** The light emitting device of any one of claims 1-43, wherein:
in at least part of the circuits, the conduction time of the energy storage circuit and the power supply are different; and/or the conduction time of the energy storage circuit and the laser emitter are different.

**45.** A distance measuring device, comprising:

the light emitting device according to any one of claims 1-44 configured to emit laser pulse signals in sequence;
at least two detection circuits respectively corresponding to the at least two laser emission circuits, wherein each detection circuit includes:

a photoelectric conversion circuit configured to receive at least part of an optical signal of the laser pulse signal emitted by the corresponding laser emission circuit reflected by an object, and convert the received optical signal into an electrical signal;

a sampling circuit configured to sample the electrical signal from the photoelectric conversion circuit to obtain a sampling result; and

an arithmetic circuit configured to calculate a distance between the object and the distance measuring device based on the sampling result.

46. The distance measuring device of claim 45, wherein: the at least two detection circuits share at least part of the sampling circuit; and/or the at least two detection circuits share at least part of the arithmetic circuit.

47. The distance measuring device of claim 45 or 46 further comprising: a scanning module, the scanning module being configured to emit the laser pulse signal from the light emitting device after changing its transmission direction, and transmit the laser pulse signal reflected by the object to a detection circuit after passing through the scanning module.

48. The distance measuring device of claim 47, wherein: the scanning module includes a driver and a prism with uneven thickness, the driver being configured to drive the prism to rotate to change the laser pulse signal passing through the prism to different directions.

49. The distance measuring device of claim 48 wherein: the scanning module includes two drivers, and two parallel prisms with uneven thickness, the two drivers being configured to drive the two prisms to rotate in opposite directions, the laser pulse signal from the light emitting device changing the transmission direction and emitting after passing through the two prisms.

50. A mobile platform comprising:

the distance measuring device according to any one of claims 45-49; and
a platform body, the light emitting device of the distance measuring device being mounted on the platform body.

51. The mobile platform of claim 50, wherein: the mobile platform includes at least one of an unmanned aerial vehicle, a vehicle, and a robot.

FIG. 1

FIG. 2

EP 3 910 374 A1

**FIG. 3**

**FIG. 4**

**FIG. 5**

**FIG. 6**

**FIG. 7**

**FIG. 8**

**FIG. 9**

**FIG. 10**

**FIG. 11**

**FIG. 12**

**FIG. 13**

**FIG. 14**

**FIG. 15**

**FIG. 16**

**FIG. 17**

**FIG. 18**

**FIG. 19**

**FIG. 20**

**FIG. 21**

**FIG. 22**

**FIG. 23**

**FIG. 24**

**FIG. 25**

**FIG. 26**

**FIG. 27**

## INTERNATIONAL SEARCH REPORT

International application No.

**PCT/CN2019/071035**

**A.    CLASSIFICATION OF SUBJECT MATTER**

G01S 7/484(2006.01)i;   G01S 17/08(2006.01)i;   H01S 5/042(2006.01)i

According to International Patent Classification (IPC) or to both national classification and IPC

**B.    FIELDS SEARCHED**

Minimum documentation searched (classification system followed by classification symbols)

G01S 7; G01S 17; G01S 13; H01S 5; H02H 9; H04L 12; H03

Documentation searched other than minimum documentation to the extent that such documents are included in the fields searched

Electronic data base consulted during the international search (name of data base and, where practicable, search terms used)

CNABS, CNKI, CNTXT, VEN: 激光, 储能, 蓄能, 充电, 开关, MOS, 晶体管, 三极管, 电容, 多线, 多条, 多路, 若干, 数, 至少一, 两, 三, 阵列, laser, stor+, memor+, energy, elect+, switch+, multi+, plural, some, two, three, couple, array

**C.    DOCUMENTS CONSIDERED TO BE RELEVANT**

| Category* | Citation of document, with indication, where appropriate, of the relevant passages | Relevant to claim No. |
|---|---|---|
| E | CN 109116366 A (HESAI PHOTONICS TECHNOLOGY CO., LTD.) 01 January 2019 (2019-01-01)<br>    description, paragraphs [0034] and [0059]-[0084], and figures 12-18 | 1, 2, 11, 44 |
| E | CN 209389446 U (BEIJING VANJEE TECHNOLOGY CO., LTD.) 13 September 2019 (2019-09-13)<br>    description, paragraphs [0006]-[0039], and figure 1 | 1 |
| X | US 9368936 B1 (GOOGLE INC.) 14 June 2016 (2016-06-14)<br>    description, column 4, line 45 to column 5, line 35 and column 17, line 47 to column 27, line 63, and figures 5A-7 | 1-51 |
| X | CN 108631151 A (CHENGDU ULTRARANGE TECHNOLOGY CO., LTD.) 09 October 2018 (2018-10-09)<br>    description, paragraphs [0040]-[0048] and [0055]-[0085], and figures 3, 5 and 6 | 1-51 |
| X | CN 203554404 U (INSTITUTE OF FLUID PHYSICS, CHINA ACADEMY OF ENGINEERING PHYSICS) 16 April 2014 (2014-04-16)<br>    description, paragraphs [0006]-[0010] and [0038], and figures 1 and 4 | 1-51 |
| A | JP 2016127214 A (RICOH CO., LTD.) 11 July 2016 (2016-07-11)<br>    entire document | 1–51 |

☑ Further documents are listed in the continuation of Box C.          ☑ See patent family annex.

|   |   |   |   |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 October 2019** | **14 October 2019** |

| Name and mailing address of the ISA/CN | Authorized officer |
|---|---|
| **China National Intellectual Property Administration (ISA/CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2019/071035** |

**C.    DOCUMENTS CONSIDERED TO BE RELEVANT**

| Category* | Citation of document, with indication, where appropriate, of the relevant passages | Relevant to claim No. |
|---|---|---|
| A | CN 203242917 U (FUDAN UNIVERSITY) 16 October 2013 (2013-10-16)<br>entire document | 1–51 |

Form PCT/ISA/210 (second sheet) (January 2015)

**INTERNATIONAL SEARCH REPORT**
Information on patent family members

International application No.

**PCT/CN2019/071035**

| Patent document cited in search report | | | Publication date (day/month/year) | Patent family member(s) | | | Publication date (day/month/year) |
|---|---|---|---|---|---|---|---|
| CN | 109116366 | A | 01 January 2019 | None | | | |
| CN | 209389446 | U | 13 September 2019 | None | | | |
| US | 9368936 | B1 | 14 June 2016 | US | 10277007 | B1 | 30 April 2019 |
| | | | | US | 10141716 | B1 | 27 November 2018 |
| | | | | US | 9368936 | C1 | 15 January 2019 |
| CN | 108631151 | A | 09 October 2018 | None | | | |
| CN | 203554404 | U | 16 April 2014 | None | | | |
| JP | 2016127214 | A | 11 July 2016 | None | | | |
| CN | 203242917 | U | 16 October 2013 | None | | | |

Form PCT/ISA/210 (patent family annex) (January 2015)